# EUROPEAN PATENT APPLICATION

(11) **EP 4 608 082 A1**
(43) Date of publication of application: **27.08.2025**
(21) Application number: 24827708.9
(22) Date of filing: 31.12.2024
(51) Int. Cl.: H05K 7/20, H05K 1/11, H05K 9/00

(54) **ELECTRONIC DEVICE COMPRISING HEAT DISSIPATION STRUCTURE**

(30) Priority: 03.01.2024 KR 20240001215; 21.03.2024 KR 20240039336
(71) Applicant: Samsung Electronics Co., Ltd, Suwon-si, Gyeonggi-do 16677 (KR)
(72) Inventor: KWON, Ohhyuck, Gyeonggi-do 16677 (KR); PARK, Min, Gyeonggi-do 16677 (KR); SUNG, Jungoh, Gyeonggi-do 16677 (KR); SON, Changjong, Gyeonggi-do 16677 (KR); YOON, Jeonggen, Gyeonggi-do 16677 (KR); PARK, Sungchul, Gyeonggi-do 16677 (KR)
(74) Representative: HGF
(86) International application number: PCT/KR2024/021551
(87) International publication number: WO 2025/147053

(57) **Abstract**

The disclosure relates to an electronic device. The electronic device according to an embodiment of the disclosure may include a first printed circuit board including a first surface and a second surface which is opposite the first surface, a second printed circuit board spaced apart from the first printed circuit board and including a third surface which faces the first surface and a fourth surface which is opposite the third surface, an interposer disposed between the first printed circuit board and the second printed circuit board, the interposer extending along at least a portion of an edge of the third surface to define an inside space, an electronic component mounted on the fourth surface of the second printed circuit board, a shield can mounted on the first surface of the first printed circuit board, and a heat dissipation material positioned between the third surface and the shield can.

## Description

### [Technical Field]

The disclosure relates to an electronic device, for example, an electronic device including a heat dissipation structure for electronic components.

### [Background Art]

The term "electronic device" may refer to a device that performs a specific function according to an installed program, such as a home appliance, an electronic scheduler, a portable multimedia player, a mobile communication terminal, a tablet PC, an image and sound device, a desktop or laptop PC, or a vehicle navigation system. For example, these electronic devices may output stored information as sound or images.

As the integration degree of electronic devices increases and ultra-high-speed and high-capacity wireless communication become more widespread, a single electronic device such as a mobile communication terminal may now be equipped with various functions. For example, not only communication functions but also entertainment functions such as gaming, multimedia functions such as music and video playback, communication and security functions such as mobile banking, as well as schedule management and electronic wallet functions, are being integrated into a single electronic device. These electronic devices are being smaller to be conveniently carried by users.

### [Detailed Description of the Invention]

### [Technical Solution]

An electronic device according to an embodiment of the disclosure may include a first printed circuit board including a first surface and a second surface which is opposite the first surface, a second printed circuit board spaced apart from the first printed circuit board and including a third surface which faces the first surface and a fourth surface which is opposite the third surface, an interposer disposed between the first printed circuit board and the second printed circuit board, the interposer extending along at least a portion of an edge of the third surface to define an inside space, an electronic component mounted on the fourth surface of the second printed circuit board, a shield can mounted on the first surface of the first printed circuit board, and a heat dissipation material positioned between the third surface and the shield can.

An electronic device according to an embodiment of the disclosure may include a first printed circuit board including a first surface and a second surface which is opposite the first surface, a second printed circuit board spaced apart from the first printed circuit board and including a third surface which faces the first surface and a fourth surface which is opposite the third surface, an interposer disposed between the first printed circuit board and the second printed circuit board, the interposer extending along at least a portion of an edge of the third surface to define an inside space, an electronic component mounted on the fourth surface of the second printed circuit board, a shield can mounted on the first surface of the first printed circuit board, a heat dissipation material positioned between the third surface and the shield can, and a heat dispersion member positioned between a first outer surface of the electronic device and the electronic component and extending along the first outer surface of the electronic device. The shield can may be positioned between the electronic component and a second outer surface of the electronic device which is opposite the first outer surface of the electronic device.

### [Brief Description of Drawings]

FIG. 1 is a block diagram illustrating an electronic device 101 in a network environment 100 according to various embodiments.
FIG. 2 is a perspective view of an electronic device according to an embodiment of the disclosure, illustrating the front surface of the electronic device.
FIG. 3 is a perspective view of the electronic device according to an embodiment of the disclosure, illustrating the rear surface of the electronic device.
FIG. 4 is an exploded perspective view of the electronic device according to an embodiment of the disclosure, illustrating the front surface of the electronic device.
FIG. 5 is a cross-sectional view of a portion of an electronic device according to an embodiment of the disclosure.
FIG. 6 is a cross-sectional view of a portion of an electronic device according to an embodiment of the disclosure.
FIG. 7 is a view illustrating how a heat dissipation material is injected into an inside space between a first printed circuit board and a second printed circuit board, according to an embodiment of the disclosure.
FIG. 8 is a view illustrating the distribution of a heat dissipation material on the first printed circuit board, according to an embodiment of the disclosure.
FIG. 9 is a view illustrating the distribution of a heat dissipation material on the second printed circuit board, according to an embodiment of the disclosure.
FIG. 10 is a view illustrating a plurality of areas projected onto the second printed circuit board according to an embodiment of the disclosure.
FIG. 11 is a view illustrating the arrangement of a plurality of shield cans and a through hole according to an embodiment of the disclosure.
FIG. 12 illustrates a state in which the shield cans are removed from FIG. 11 according to an embodiment of the disclosure.
FIG. 13 is a graph showing the temperature of an electronic component depending on the amount of an injected heat dissipation material according to an embodiment of the disclosure.
FIG. 14 illustrates the position of the heat dissipation material on the first printed circuit board according to an embodiment of the disclosure.
FIG. 15 illustrates the position of the heat dissipation material on the second printed circuit board according to an embodiment of the disclosure.
FIG. 16 illustrates a plurality of areas projected onto the second printed circuit board according to an embodiment of the disclosure.
FIG. 17 illustrates a shield can and a heat dissipation material, according to an embodiment of the disclosure.
FIG. 18 illustrates a plurality of areas on a second printed circuit board, according to an embodiment of the disclosure.
FIG. 19 is a cross-sectional view of a portion of an electronic device, illustrating a plurality of shield cans according to an embodiment of the disclosure.
FIG. 20 is a cross-sectional view of a portion of an electronic device, illustrating a first interposer and a second interposer according to an embodiment of the disclosure.
FIG. 21 illustrates a first printed circuit board according to an embodiment of the disclosure.
FIG. 22 illustrates a second printed circuit board and an interposer according to an embodiment of the disclosure.
FIG. 23 is a cross-sectional view of a portion of an electronic device according to an embodiment of the disclosure.
FIG. 24 illustrates electronic components and a solid-state heat transfer member, which is disposed on the electronic components, as viewed from two directions, according to an embodiment of the disclosure.
FIG. 25 illustrates electronic components and a gel-state heat transfer member, which is pressed by a conductive layer, as viewed from two directions, according to an embodiment of the disclosure.

### [Mode for Carrying out the Invention]

The following description made with reference to the accompanying drawings may provide an understanding of various exemplary implementations of the disclosure including the claims and equivalents thereof. An exemplary embodiment set forth in the following description includes various particular details to help the understanding, but is considered one of various exemplary embodiments. Therefore, it will be apparent to those skilled in the art that various changes and modifications may be made to various implementations described herein without departing from the scope and technical idea of the disclosure. In addition, descriptions of well-known functions and configurations may be omitted for clarity and brevity.

The terms and words used in the following description and claims are not limited to bibliographical meanings, but may be used to clearly and consistently describe the various embodiments set forth herein. Therefore, it will be apparent to those skilled in the art that the following description of various implementations of the disclosure is provided only for the purpose of explanation, rather than for the purpose of limiting the disclosure defined as the scope of protection and equivalents thereto.

It should be appreciated that a singular form such as and claims or "the" also includes the meaning as a plural form, unless the context clearly indicates otherwise. Therefore, for example, "a component surface" may mean one or more of component surfaces.

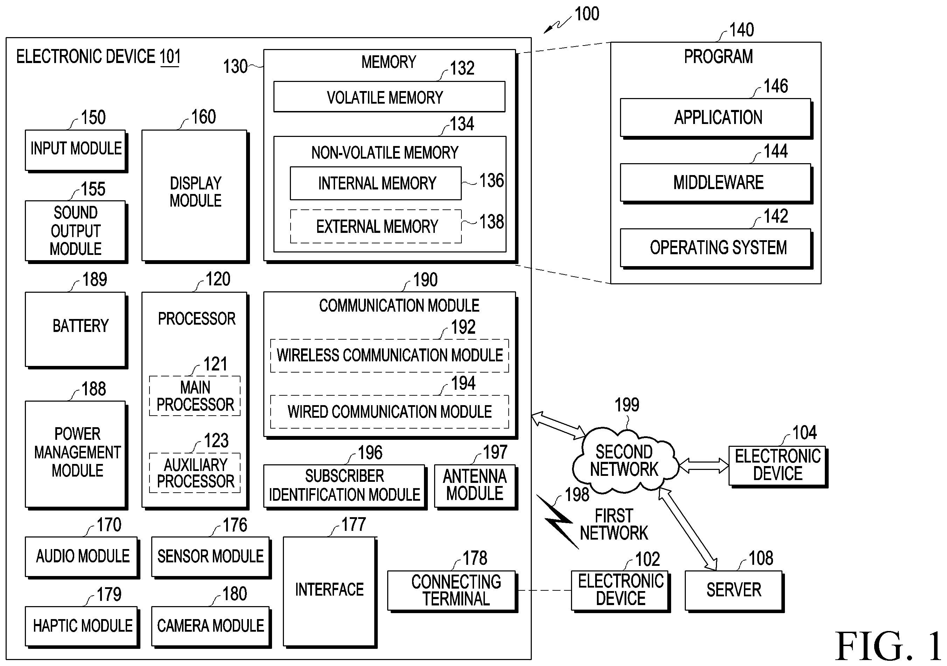

FIG. 1 is a block diagram illustrating an electronic device 101 in a network environment 100 according to various embodiments.

Referring to FIG. 1, the electronic device 101 in the network environment 100 may communicate with an electronic device 102 via a first network 198 (e.g., a short-range wireless communication network), or at least one of an electronic device 104 or a server 108 via a second network 199 (e.g., a long-range wireless communication network). According to an embodiment, the electronic device 101 may communicate with the electronic device 104 via the server 108. According to an embodiment, the electronic device 101 may include a processor 120, memory 130, an input module 150, a sound output module 155, a display module 160, an audio module 170, a sensor module 176, an interface 177, a connecting terminal 178, a haptic module 179, a camera module 180, a power management module 188, a battery 189, a communication module 190, a subscriber identification module (SIM) 196, or an antenna module 197. In some embodiments, at least one of the components (e.g., the connecting terminal 178) may be omitted from the electronic device 101, or one or more other components may be added in the electronic device 101. In some embodiments, some of the components (e.g., the sensor module 176, the camera module 180, or the antenna module 197) may be implemented as a single component (e.g., the display module 160).

The processor 120 may execute, for example, software (e.g., a program 140) to control at least one other component (e.g., a hardware or software component) of the electronic device 101 coupled with the processor 120, and may perform various data processing or computation. According to one embodiment, as at least part of the data processing or computation, the processor 120 may store a command or data received from another component (e.g., the sensor module 176 or the communication module 190) in volatile memory 132, process the command or the data stored in the volatile memory 132, and store resulting data in non-volatile memory 134. According to an embodiment, the processor 120 may include a main processor 121 (e.g., a central processing unit (CPU) or an application processor (AP)), or an auxiliary processor 123 (e.g., a graphics processing unit (GPU), a neural processing unit (NPU), an image signal processor (ISP), a sensor hub processor, or a communication processor (CP)) that is operable independently from, or in conjunction with, the main processor 121. For example, when the electronic device 101 includes the main processor 121 and the auxiliary processor 123, the auxiliary processor 123 may be adapted to consume less power than the main processor 121, or to be specific to a specified function. The auxiliary processor 123 may be implemented as separate from, or as part of the main processor 121.

The auxiliary processor 123 may control at least some of functions or states related to at least one component (e.g., the display module 160, the sensor module 176, or the communication module 190) among the components of the electronic device 101, instead of the main processor 121 while the main processor 121 is in an inactive (e.g., sleep) state, or together with the main processor 121 while the main processor 121 is in an active state (e.g., executing an application). According to an embodiment, the auxiliary processor 123 (e.g., an image signal processor or a communication processor) may be implemented as part of another component (e.g., the camera module 180 or the communication module 190) functionally related to the auxiliary processor 123. According to an embodiment, the auxiliary processor 123 (e.g., the neural processing unit) may include a hardware structure specified for artificial intelligence model processing. An artificial intelligence model may be generated by machine learning. Such learning may be performed, e.g., by the electronic device 101 where the artificial intelligence is performed or via a separate server (e.g., the server 108). Learning algorithms may include, but are not limited to, e.g., supervised learning, unsupervised learning, semi-supervised learning, or reinforcement learning. The artificial intelligence model may include a plurality of artificial neural network layers. The artificial neural network may be a deep neural network (DNN), a convolutional neural network (CNN), a recurrent neural network (RNN), a restricted Boltzmann machine (RBM), a deep belief network (DBN), a bidirectional recurrent deep neural network (BRDNN), deep Q-network or a combination of two or more thereof but is not limited thereto. The artificial intelligence model may, additionally or alternatively, include a software structure other than the hardware structure.

The memory 130 may store various data used by at least one component (e.g., the processor 120 or the sensor module 176) of the electronic device 101. The various data may include, for example, software (e.g., the program 140) and input data or output data for a command related thereto. The memory 130 may include the volatile memory 132 or the non-volatile memory 134.

The program 140 may be stored in the memory 130 as software, and may include, for example, an operating system (OS) 142, middleware 144, or an application 146.

The input module 150 may receive a command or data to be used by another component (e.g., the processor 120) of the electronic device 101, from the outside (e.g., a user) of the electronic device 101. The input module 150 may include, for example, a microphone, a mouse, a keyboard, a key (e.g., a button), or a digital pen (e.g., a stylus pen).

The sound output module 155 may output sound signals to the outside of the electronic device 101. The sound output module 155 may include, for example, a speaker or a receiver. The speaker may be used for general purposes, such as playing multimedia or playing record. The receiver may be used for receiving incoming calls. According to an embodiment, the receiver may be implemented as separate from, or as part of the speaker.

The display module 160 may visually provide information to the outside (e.g., a user) of the electronic device 101. The display module 160 may include, for example, a display, a hologram device, or a projector and control circuitry to control a corresponding one of the display, hologram device, and projector. According to an embodiment, the display module 160 may include a touch sensor adapted to detect a touch, or a pressure sensor adapted to measure the intensity of force incurred by the touch.

The audio module 170 may convert a sound into an electrical signal and vice versa. According to an embodiment, the audio module 170 may obtain the sound via the input module 150, or output the sound via the sound output module 155 or a headphone of an external electronic device (e.g., an electronic device 102) directly (e.g., wiredly) or wirelessly coupled with the electronic device 101.

The sensor module 176 may detect an operational state (e.g., power or temperature) of the electronic device 101 or an environmental state (e.g., a state of a user) external to the electronic device 101, and then generate an electrical signal or data value corresponding to the detected state. According to an embodiment, the sensor module 176 may include, for example, a gesture sensor, a gyro sensor, an atmospheric pressure sensor, a magnetic sensor, an acceleration sensor, a grip sensor, a proximity sensor, a color sensor, an infrared (IR) sensor, a biometric sensor, a temperature sensor, a humidity sensor, or an illuminance sensor.

The interface 177 may support one or more specified protocols to be used for the electronic device 101 to be coupled with the external electronic device (e.g., the electronic device 102) directly (e.g., wiredly) or wirelessly. According to an embodiment, the interface 177 may include, for example, a high definition multimedia interface (HDMI), a universal serial bus (USB) interface, a secure digital (SD) card interface, or an audio interface.

A connecting terminal 178 may include a connector via which the electronic device 101 may be physically connected with the external electronic device (e.g., the electronic device 102). According to an embodiment, the connecting terminal 178 may include, for example, a HDMI connector, a USB connector, a SD card connector, or an audio connector (e.g., a headphone connector).

The haptic module 179 may convert an electrical signal into a mechanical stimulus (e.g., a vibration or a movement) or electrical stimulus which may be recognized by a user via his tactile sensation or kinesthetic sensation. According to an embodiment, the haptic module 179 may include, for example, a motor, a piezoelectric element, or an electric stimulator.

The camera module 180 may capture a still image or moving images. According to an embodiment, the camera module 180 may include one or more lenses, image sensors, image signal processors, or flashes.

The power management module 188 may manage power supplied to the electronic device 101. According to one embodiment, the power management module 188 may be implemented as at least part of, for example, a power management integrated circuit (PMIC).

The battery 189 may supply power to at least one component of the electronic device 101. According to an embodiment, the battery 189 may include, for example, a primary cell which is not rechargeable, a secondary cell which is rechargeable, or a fuel cell.

The communication module 190 may support establishing a direct (e.g., wired) communication channel or a wireless communication channel between the electronic device 101 and the external electronic device (e.g., the electronic device 102, the electronic device 104, or the server 108) and performing communication via the established communication channel. The communication module 190 may include one or more communication processors that are operable independently from the processor 120 (e.g., the application processor (AP)) and supports a direct (e.g., wired) communication or a wireless communication. According to an embodiment, the communication module 190 may include a wireless communication module 192 (e.g., a cellular communication module, a short-range wireless communication module, or a global navigation satellite system (GNSS) communication module) or a wired communication module 194 (e.g., a local area network (LAN) communication module or a power line communication (PLC) module). A corresponding one of these communication modules may communicate with the external electronic device via the first network 198 (e.g., a short-range communication network, such as BluetoothTM, wireless-fidelity (Wi-Fi) direct, or infrared data association (IrDA)) or the second network 199 (e.g., a long-range communication network, such as a legacy cellular network, a 5G network, a next-generation communication network, the Internet, or a computer network (e.g., LAN or wide area network (WAN)). These various types of communication modules may be implemented as a single component (e.g., a single chip), or may be implemented as multi components (e.g., multi chips) separate from each other. The wireless communication module 192 may identify and authenticate the electronic device 101 in a communication network, such as the first network 198 or the second network 199, using subscriber information (e.g., international mobile subscriber identity (IMSI)) stored in the subscriber identification module 196.

The wireless communication module 192 may support a 5G network, after a 4G network, and next-generation communication technology, e.g., new radio (NR) access technology. The NR access technology may support enhanced mobile broadband (eMBB), massive machine type communications (mMTC), or ultra-reliable and low-latency communications (URLLC). The wireless communication module 192 may support a high-frequency band (e.g., the mmWave band) to achieve, e.g., a high data transmission rate. The wireless communication module 192 may support various technologies for securing performance on a high-frequency band, such as, e.g., beamforming, massive multiple-input and multiple-output (massive MIMO), full dimensional MIMO (FD-MIMO), array antenna, analog beam-forming, or large scale antenna. The wireless communication module 192 may support various requirements specified in the electronic device 101, an external electronic device (e.g., the electronic device 104), or a network system (e.g., the second network 199). According to an embodiment, the wireless communication module 192 may support a peak data rate (e.g., 20Gbps or more) for implementing eMBB, loss coverage (e.g., 164dB or less) for implementing mMTC, or U-plane latency (e.g., 0.5ms or less for each of downlink (DL) and uplink (UL), or a round trip of 1ms or less) for implementing URLLC.

The antenna module 197 may transmit or receive a signal or power to or from the outside (e.g., the external electronic device) of the electronic device 101. According to an embodiment, the antenna module 197 may include an antenna including a radiating element composed of a conductive material or a conductive pattern formed in or on a substrate (e.g., a printed circuit board (PCB)). According to an embodiment, the antenna module 197 may include a plurality of antennas (e.g., array antennas). In such a case, at least one antenna appropriate for a communication scheme used in the communication network, such as the first network 198 or the second network 199, may be selected, for example, by the communication module 190 (e.g., the wireless communication module 192) from the plurality of antennas. The signal or the power may then be transmitted or received between the communication module 190 and the external electronic device via the selected at least one antenna. According to an embodiment, another component (e.g., a radio frequency integrated circuit (RFIC)) other than the radiating element may be additionally formed as part of the antenna module 197.

According to various embodiments, the antenna module 197 may form a mmWave antenna module. According to an embodiment, the mmWave antenna module may include a printed circuit board, a RFIC disposed on a first surface (e.g., the bottom surface) of the printed circuit board, or adjacent to the first surface and capable of supporting a designated high-frequency band (e.g., the mmWave band), and a plurality of antennas (e.g., array antennas) disposed on a second surface (e.g., the top or a side surface) of the printed circuit board, or adjacent to the second surface and capable of transmitting or receiving signals of the designated high-frequency band.

At least some of the above-described components may be coupled mutually and communicate signals (e.g., commands or data) therebetween via an inter-peripheral communication scheme (e.g., a bus, general purpose input and output (GPIO), serial peripheral interface (SPI), or mobile industry processor interface (MIPI)).

According to an embodiment, commands or data may be transmitted or received between the electronic device 101 and the external electronic device 104 via the server 108 coupled with the second network 199. Each of the electronic devices 102 or 104 may be a device of a same type as, or a different type, from the electronic device 101. According to an embodiment, all or some of operations to be executed at the electronic device 101 may be executed at one or more of the external electronic devices 102, 104, or 108. For example, if the electronic device 101 should perform a function or a service automatically, or in response to a request from a user or another device, the electronic device 101, instead of, or in addition to, executing the function or the service, may request the one or more external electronic devices to perform at least part of the function or the service. The one or more external electronic devices receiving the request may perform the at least part of the function or the service requested, or an additional function or an additional service related to the request, and transfer an outcome of the performing to the electronic device 101. The electronic device 101 may provide the outcome, with or without further processing of the outcome, as at least part of a reply to the request. To that end, a cloud computing, distributed computing, mobile edge computing (MEC), or client-server computing technology may be used, for example. The electronic device 101 may provide ultra low-latency services using, e.g., distributed computing or mobile edge computing. In another embodiment, the external electronic device 104 may include an internet-of-things (IoT) device. The server 108 may be an intelligent server using machine learning and/or a neural network. According to an embodiment, the external electronic device 104 or the server 108 may be included in the second network 199. The electronic device 101 may be applied to intelligent services (e.g., smart home, smart city, smart car, or healthcare) based on 5G communication technology or IoT-related technology.

The electronic device according to various embodiments may be one of various types of electronic devices. The electronic devices may include, for example, a portable communication device (e.g., a smartphone), a computer device, a portable multimedia device, a portable medical device, a camera, a wearable device, or a home appliance. According to an embodiment of the disclosure, the electronic devices are not limited to those described above.

It should be appreciated that various embodiments of the present disclosure and the terms used therein are not intended to limit the technological features set forth herein to particular embodiments and include various changes, equivalents, or replacements for a corresponding embodiment. With regard to the description of the drawings, similar reference numerals may be used to refer to similar or related elements. It is to be understood that a singular form of a noun corresponding to an item may include one or more of the things, unless the relevant context clearly indicates otherwise. As used herein, each of such phrases as "A or B," "at least one of A and B," "at least one of A or B," "A, B, or C," "at least one of A, B, and C," and "at least one of A, B, or C," may include any one of, or all possible combinations of the items enumerated together in a corresponding one of the phrases. As used herein, such terms as "1st" and "2nd," or "first" and "second" may be used to simply distinguish a corresponding component from another, and does not limit the components in other aspect (e.g., importance or order). It is to be understood that if an element (e.g., a first element) is referred to, with or without the term "operatively" or "communicatively", as "coupled with," "coupled to," "connected with," or "connected to" another element (e.g., a second element), it means that the element may be coupled with the other element directly (e.g., wiredly), wirelessly, or via a third element.

As used in connection with various embodiments of the disclosure, the term "module" may include a unit implemented in hardware, software, or firmware, and may interchangeably be used with other terms, for example, "logic," "logic block," "part," or "circuitry". A module may be a single integral component, or a minimum unit or part thereof, adapted to perform one or more functions. For example, according to an embodiment, the module may be implemented in a form of an application-specific integrated circuit (ASIC).

Various embodiments as set forth herein may be implemented as software (e.g., the program 140) including one or more instructions that are stored in a storage medium (e.g., internal memory 136 or external memory 138) that is readable by a machine (e.g., the electronic device 101). For example, a processor (e.g., the processor 120) of the machine (e.g., the electronic device 101) may invoke at least one of the one or more instructions stored in the storage medium, and execute it, with or without using one or more other components under the control of the processor. This allows the machine to be operated to perform at least one function according to the at least one instruction invoked. The one or more instructions may include a code generated by a complier or a code executable by an interpreter. The machine-readable storage medium may be provided in the form of a non-transitory storage medium. Wherein, the term "non-transitory" simply means that the storage medium is a tangible device, and does not include a signal (e.g., an electromagnetic wave), but this term does not differentiate between where data is semi-permanently stored in the storage medium and where the data is temporarily stored in the storage medium.

According to an embodiment, a method according to various embodiments of the disclosure may be included and provided in a computer program product. The computer program product may be traded as a product between a seller and a buyer. The computer program product may be distributed in the form of a machine-readable storage medium (e.g., compact disc read only memory (CD-ROM)), or be distributed (e.g., downloaded or uploaded) online via an application store (e.g., PlayStore^{™}), or between two user devices (e.g., smart phones) directly. If distributed online, at least part of the computer program product may be temporarily generated or at least temporarily stored in the machine-readable storage medium, such as memory of the manufacturer's server, a server of the application store, or a relay server.

According to various embodiments, each component (e.g., a module or a program) of the above-described components may include a single entity or multiple entities, and some of the multiple entities may be separately disposed in different components. According to various embodiments, one or more of the above-described components may be omitted, or one or more other components may be added. Alternatively or additionally, a plurality of components (e.g., modules or programs) may be integrated into a single component. In such a case, according to various embodiments, the integrated component may still perform one or more functions of each of the plurality of components in the same or similar manner as they are performed by a corresponding one of the plurality of components before the integration. According to various embodiments, operations performed by the module, the program, or another component may be carried out sequentially, in parallel, repeatedly, or heuristically, or one or more of the operations may be executed in a different order or omitted, or one or more other operations may be added.

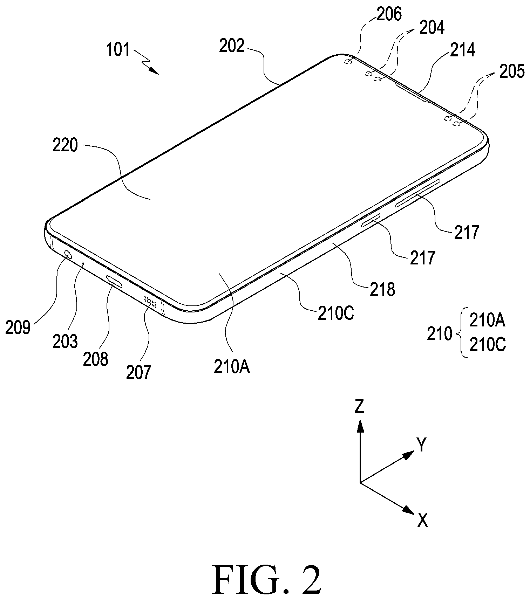

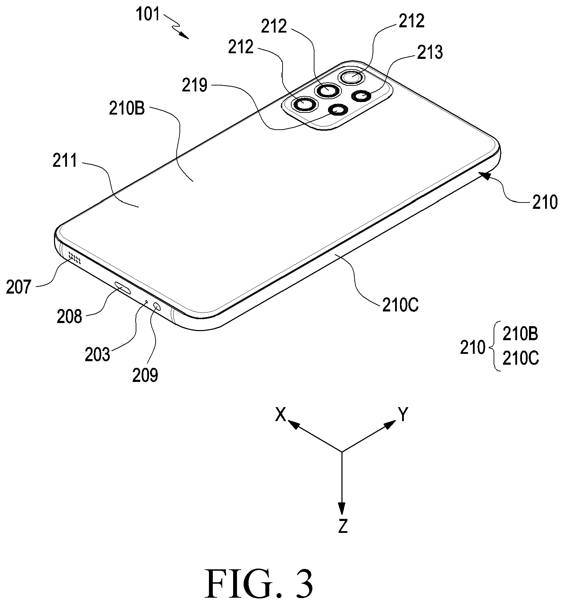

FIG. 2 is a perspective view of the electronic device 101 according to an embodiment of the disclosure, illustrating the front surface 210A of the electronic device 101. FIG. 3 is a perspective view of the electronic device 101 according to an embodiment of the disclosure, illustrating the rear surface 210B of the electronic device 101.

Referring to FIGS. 2 and 3, according to an embodiment of the disclosure, the electronic device 101 may include a first outer surface (or a front surface) 210A, a second outer surface (or a rear surface) 210B, and a third outer surface (or a side surface) 210C surrounding the space between the first surface 210A and the second surface 210B.

According to an embodiment of the disclosure, at least a portion of the first surface 210A may be made of a substantially transparent front surface plate 202 (e.g., a glass plate or a polymer plate including various coating layers). The second surface 210B may be made of a substantially opaque rear surface plate 211. The rear surface plate 211 may be made of, for example, coated or colored glass, ceramic, polymer, metal (e.g., aluminum, stainless steel (STS), or magnesium), or a combination of two or more of these materials. The side surface 210C may be defined by the side surface structure (or a "side surface bezel structure embodiment of the disclosure, at least a 202 and the rear surface plate 211 and including metal and/or polymer. In an embodiment, the rear surface plate 211 and the side surface structure 218 may be integrated with each other and may include the same material (e.g., a metal material such as aluminum).

According to an embodiment of the disclosure, the electronic device 101 may include at least one of a display 220, audio modules 203, 207, and 214, sensor modules 204 and 219, camera modules 205, 212, and 213, key input devices 217, light-emitting elements 206, and connector holes 208 and 209. In an embodiment, in the electronic device 101, at least one of the components (e.g., the key input devices 217 or the light-emitting element 206) may be omitted, or other components may be additionally included.

According to an embodiment of the disclosure, the display 220 may be visually exposed through a substantial portion of, for example, the front surface plate 202. In an embodiment, at least a portion of the display 220 may be visually exposed through the front surface plate 202 forming the first surface 210A or through a portion of the side surface 210C. In an embodiment, the edges of the display 220 may be formed to be substantially the same as the shape of the periphery of the front surface plate 202 adjacent thereto.

In an embodiment of the disclosure (not illustrated), recesses or openings may be provided in a portion of the screen display area of the display 220, and one or more of the audio module 214, the sensor modules 204, the camera modules 205, and the light-emitting elements 206, which are aligned with the recesses or the openings, may be included. In an embodiment of the disclosure (not illustrated), the rear surface of the screen display area of the display 220 may include at least one of the audio module 214, the sensor modules 204, the camera modules 205, a fingerprint sensor (not illustrated), and the light-emitting elements 206. In an embodiment of the disclosure (not illustrated), the display 220 may be coupled to or disposed adjacent to a touch-sensitive circuit, a pressure sensor capable of measuring a touch intensity (pressure), and/or a digitizer configured to detect an electromagnetic field-type stylus pen.

According to an embodiment of the disclosure, the audio modules 203, 207, and 214 may include a microphone hole 203 and speaker holes 207 and 214. A microphone configured to acquire external sound may be placed inside the microphone hole 203, and in an embodiment, a plurality of microphones may be placed to detect the direction of sound. The speaker holes 207 and 214 may include an external speaker hole 207 and a communication receiver hole 214. In an embodiment, the speaker holes 207 and 214 and the microphone hole 203 may be implemented as a single hole, or a speaker (e.g., a piezo speaker) may be included without the speaker holes 207 and 214.

According to an embodiment of the disclosure, the sensor modules 204 and 219 may generate electrical signals or data values corresponding to an internal operating state or an external environmental state of the electronic device 101. The sensor modules 204 and 219 may include, for example, a first sensor module 204 (e.g., a proximity sensor) and/or a second sensor module (not illustrated) (e.g., a fingerprint sensor) disposed on the first surface 210A of the housing 210, and/or a third sensor module 219 and/or a fourth sensor module (e.g., a fingerprint sensor) disposed on the second surface 210B of the housing 210. The fingerprint sensor may be disposed not only on the first surface 210A (e.g., the display 220) of the housing 210, but also on the second surface 210B or the side surface 210C of the housing 110. The electronic device 101 may further include at least one of, for example, a gesture sensor, a gyro sensor, an atmospheric pressure sensor, a magnetic sensor, an acceleration sensor, a grip sensor, a color sensor, an infrared (IR) sensor, a biometric sensor, a temperature sensor, a humidity sensor, or an illuminance sensor.

According to an embodiment of the disclosure, the camera modules 205, 212, and 213 may include a first camera device 205 disposed on the first surface 210A of the electronic device 101, and a second camera device 212 and/or a flash 213 disposed on the second surface 210B. The camera modules 205 and 212 may include one or more lenses, an image sensor, and/or an image signal processor. The flash 213 may include, for example, a light-emitting diode or a xenon lamp. In an embodiment, two or more lenses (e.g., an infrared camera lens, a wide-angle lens, and a telephoto lens) and image sensors may be disposed on one surface of the electronic device 101. In an embodiment, the flash 213 may emit infrared rays, and the infrared light emitted by the flash 213 and reflected by a subject may be received through the third sensor module 219. The electronic device 101 or the processor of the electronic device 101 may detect depth information of the subject based on a time point when infrared rays are received from the third sensor module 219.

According to an embodiment of the disclosure, the key input device 217 may be disposed on the side surface 210C of the housing 210. In an embodiment, the electronic device 101 may not include some or all of the above-mentioned key input devices 217, and key input devices 217, which are not included, may be implemented in another form, such as soft keys, on the display 220. In an embodiment, the key input devices may include a sensor module disposed on the second surface 210B of the housing 210.

According to an embodiment of the disclosure, the light-emitting element 206 may be disposed on, for example, the first surface 210A of the housing 210. The light-emitting element 206 may provide, for example, the state information of the electronic device 101 in an optical form. In an embodiment, the light-emitting element 206 may provide, for example, a light source that is linked with the operation of the camera module 205. The light-emitting element 206 may include, for example, an LED, an IR LED, and a xenon lamp.

The connector holes 208 and 209 may include a first connector hole 208 capable of accommodating a connector (e.g., a USB connector) configured to transmit/receive power and/or data to/from an external electronic device, and a second connector hole (e.g., an earphone jack) 209 capable of accommodating a connector configured to transmit/receive an audio signal to/from an external electronic device.

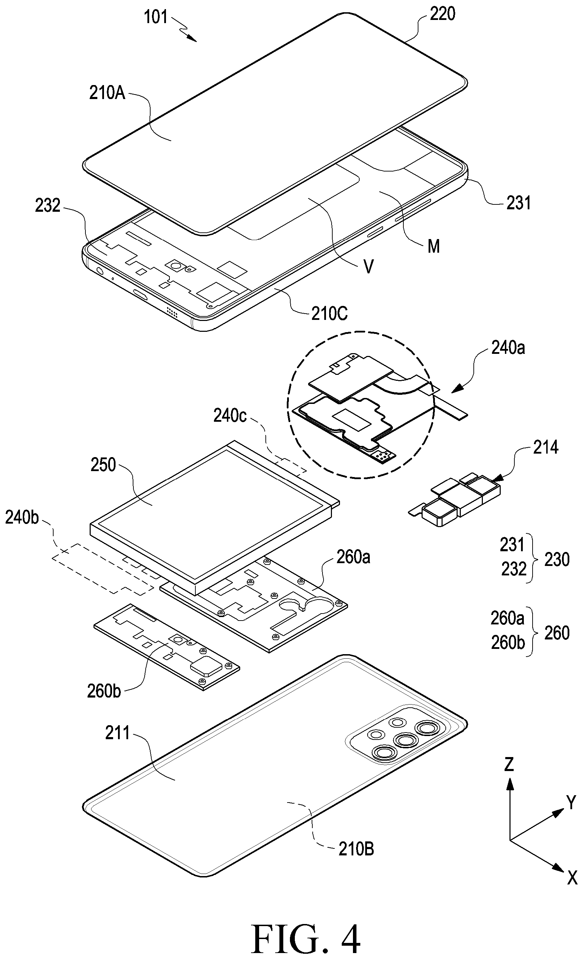

FIG. 4 is an exploded perspective view of the electronic device 101 according to an embodiment of the disclosure, illustrating the front surface 210A of the electronic device 101 (e.g., and with reference to any of the preceding Figures 1-3).

Referring to FIG. 4, according to an embodiment of the disclosure, an electronic device 101 may include a side surface structure 231, a first support member 232 (e.g., a bracket), a display 220, one or more printed circuit boards (or board assemblies) 240a and 240b, a battery 250, a second support member 260 (e.g., a rear case), an antenna, a camera assembly 214, and a rear surface plate 211. When including a plurality of printed circuit boards 240a and 240b, the electronic device 101 may comprise at least one flexible printed circuit board 240c to electrically connect different printed circuit boards. For example, the printed circuit boards 240a and 240b may include a first circuit board 240a positioned above the battery 250 and a second circuit board 240b positioned below the battery 250, and a flexible printed circuit board 240c may electrically connect the first circuit board 240a and the second circuit board 240b.

According to an embodiment of the disclosure, at least one portion of the first support member 232 may be provided in a flat shape (e.g., at least a portion thereof being a substantially flat shape). In an embodiment, the first support member 232 may be disposed inside the electronic device 101 to be connected to the side surface structure 231 or may be integrated with the side surface structure 231. The first support member 232 may be made of, for example, a metal material and/or a non-metal (e.g., polymer) material. When the first support member 232 is at least partially made of a metal material, a portion of the side surface structure 231 or the first support member 232 may serve as an antenna. The first support member 232 may include one surface to which the display 220 is coupled and the other surface to which the printed circuit boards 240a and 240b are coupled. An interposer, a processor, memory, and/or an interface may be mounted on the printed circuit boards 240a and 240b. The processor may include, for example, one or more of a central processing unit, an application processor, a graphics processing unit, an image signal processor, a sensor hub processor, or a communication processor.

According to an embodiment of the disclosure, the front surface plate 202 may be coupled to the support member 232 via an adhesive member. The front surface plate 202 may be referred to as a structure 23 "front cover". The rear surface plate 211 may be referred to as a "cover" or a "rear cover". An edge of the rear cover 211 may be supported by the support member 232.

According to an embodiment of the disclosure, the first support member 232 and the side surface structure 231 may be combined and referred to as a front case or a housing 230. The housing 230 may also be referred to as a frame 230. According to an embodiment, the housing 230 may be generally understood as a structure for accommodating, protecting, or arranging printed circuit boards 240a and 240b, and/or a battery 250. In examples, the housing 230 may be understood to support, accommodate, protect or arrange one or more further features, or components, of the electronic device 101.

In an embodiment of the disclosure, it may be understood that the housing 230 comprise structures that a user may visually or tangibly recognize in the exterior of the electronic device 101, such as the side surface structure 231, the front surface plate 202, and/or the rear surface plate 211. The housing 230 may include a side surface structure 231, a first support member 232, a front surface plate 202, and a rear surface plate 211. In an embodiment of the disclosure, the "front or rear surface of the housing 230" may refer to the front surface plate 202 or the rear surface plate 211. In an embodiment, the first support member 232 may be disposed between the front surface plate 202 and the rear surface plate 211, and may function as a structure for arranging electrical/electronic components such as the printed circuit boards 240a and 240b or the camera assembly 214.

According to an embodiment of the disclosure, the memory (e.g., the memory 130 in FIG. 1) may include, for example, a volatile memory or a nonvolatile memory.

The interface may include, for example, a high-definition multimedia interface (HDMI), a universal serial bus (USB) interface, an SD card interface, and/or an audio interface. The interface may electrically or physically connect, for example, the electronic device 101 to an external electronic device, and may include a USB connector, an SD card/MMC connector, or an audio connector.

According to an embodiment of the disclosure, the second support member 260 may include, for example, an upper support member 260a and a lower support member 260b. In an embodiment, the upper support member 260a may be disposed to surround the printed circuit board 240a or 240b (e.g., the first circuit board 240a) together with a portion of the first support member 232. For example, the upper support member 260a of the second support member 260 may be disposed to face the first support member 232 with the first circuit board 240a interposed therebetween.

In an embodiment of the disclosure, the lower support member 260b of the second support member 260 may be disposed to face the first support member 232 with the second circuit board 240b interposed therebetween. Circuit devices implemented in the form of integrated circuit chips (e.g., a processor, a communication module, or memory) or various electrical/electronic components may be disposed on a printed circuit boards 240a and 240b. According to an embodiment, the printed circuit boards 240a and 240b may be provided with an electromagnetic shielding environment from the second support member 260. In an embodiment, the lower support member 260b may be used as a structure on which electric/electronic components such as a speaker module and an interface (e.g., a USB connector, an SD card/MMC connector, or an audio connector) may be disposed.

In an embodiment of the disclosure, electrical/electronic components, such as a speaker module and an interface (e.g., a USB connector, an SD card/MMC connector, or an audio connector), may be disposed on an additional printed circuit board (not illustrated). For example, the lower support member 260b may be disposed to surround the additional printed circuit board together with the other portion of the first support member 232.

The battery 250 is a device for supplying power to at least one of the components of the electronic device 101 and may include, for example, a non-rechargeable primary battery, a rechargeable secondary battery, or a fuel cell. At least a portion of the battery 250 may be disposed on substantially the same plane as, for example, the printed circuit boards 240a and 240b. The battery 250 may be integrally disposed inside the electronic device 101 or may be detachably disposed on the electronic device 101.

Although not illustrated, the antenna may include a conductor pattern implemented on the surface of the second support member 260 through, for example, a laser direct structuring method. In an embodiment, the antenna may include a printed circuit pattern provided on the surface of a thin film, and the thin film-type antenna may be disposed between the rear surface plate 211 and the battery 250. The antenna may include, for example, a near-field communication (NFC) antenna, a wireless charging antenna, and/or a magnetic secure transmission (MST) antenna. The antenna may, for example, perform short-distance communication with an external device, or wirelessly transmit and receive power required for charging. In an embodiment, an antenna structure may be configured with a portion or a combination of the side surface structure 231 and/or the first support member 232.

According to an embodiment of the disclosure, the electronic device 101 may include a metal cover M. The metal cover M may cover the substrate assembly 240a. As an example, the metal cover M may be a portion of the housing 230 that faces the display 220 and covers the substrate assembly 240a.

According to an embodiment of the disclosure, the electronic device 101 may include a heat dispersion member V. Heat generated inside the electronic device 101 may be dispersed through the heat dispersion member V and/or may be dissipated to the outside of the electronic device 101. The heat dispersion member V may be disposed on the metal cover M. For example, heat generated from an electronic component may be transferred to the battery 250 through the heat dispersion member V. For example, the heat dispersion member V may include a vapor chamber or a heat pipe.

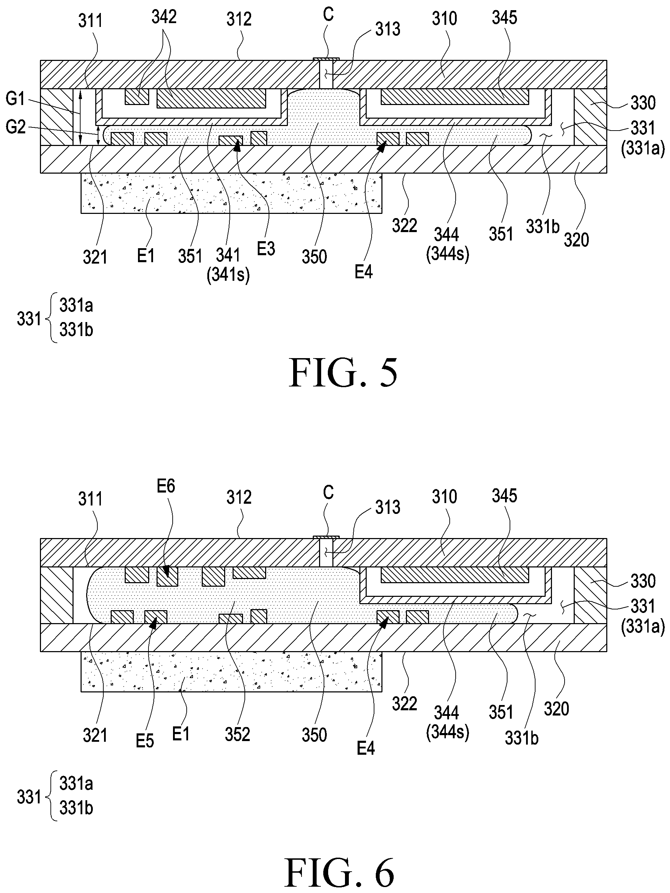

FIG. 5 illustrates a cross-sectional view of a portion of an electronic device 101 according to an embodiment of the disclosure. FIG. 6 illustrates a cross-sectional view of a portion of an electronic device 101 according to an embodiment of the disclosure.

According to an embodiment of the disclosure, an electronic device 101 may include a first printed circuit board 310. The first printed circuit board 310 may include a first surface 311 and a second surface 312 opposite the first surface 311. Components 342 and 345 of the electronic device 101 may be mounted on the first surface 311 and/or the second surface 312.

According to an embodiment of the disclosure, an electronic device 101 may include a second printed circuit board 320. The second printed circuit board 320 may be spaced apart from the first printed circuit board. The second printed circuit board 320 may be positioned to face the first printed circuit board. The second printed circuit board 320 may include a third surface 321 facing the first surface 311 of the first printed circuit board 310. The second printed circuit board 320 may include a fourth surface 322 opposite the third surface 321.

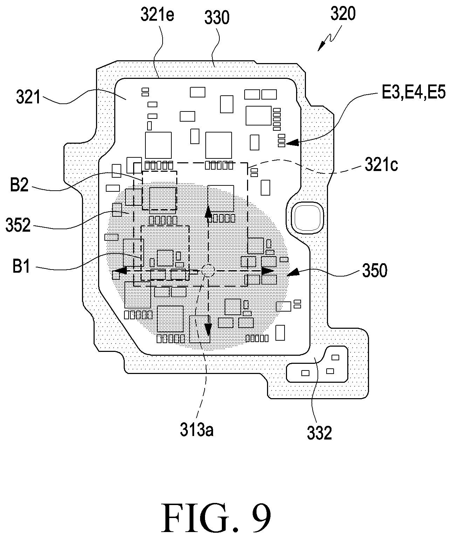

According to an embodiment of the disclosure, the electronic device 101 may comprise an interposer 330 disposed between the first printed circuit board 310 and the second printed circuit board 320. The interposer 330 may be disposed between the first surface 311 of the first printed circuit board 310 and the third surface 321 of the second printed circuit board 320. The interposer 330 may be connected to the first printed circuit board 310 and the second printed circuit board 320. The interposer 330 may include at least one via in an area 332 (see FIG. 9). The first printed circuit board 310 and the second printed circuit board 320 may be electrically or mechanically connected through the interposer 330. For example, one or more electronic components disposed on at least a portion of the first printed circuit board 310 and/or the second printed circuit board 320 may be electrically connected to each other through the at least one via included in the interposer 330.

According to an embodiment of the disclosure, the interposer 330 may extend between the first printed circuit board 310 and the second printed circuit board 320 to form an inside space 331. In examples, the inside space 331 may be formed by the first surface 311 of the first printed circuit board 310, the third surface 321 of the second printed circuit board 320, and an inward facing surface of the interposer 330 that extends between the first printed circuit board 310 and the second printed circuit board 320. A plurality of components may be disposed in the inside space 331. As an example, the interposer 330 may extend in a loop-shaped shape between the first printed circuit board 310 and the second printed circuit board 320. As another example, the interposer 330 may comprise a plurality of interposers (not illustrated), and the plurality of interposers may together form the inside space 331.

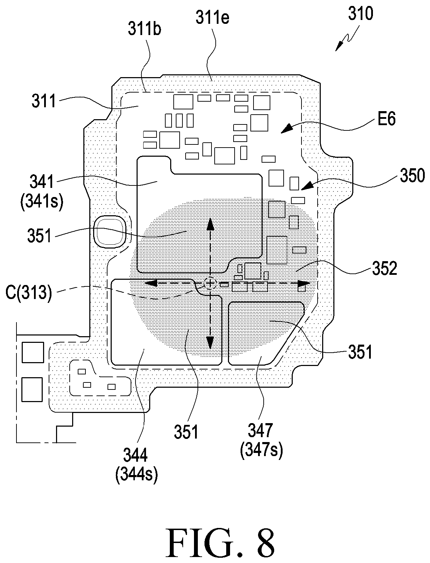

According to an embodiment of the disclosure, the interposer 330 may extend along at least a portion of an edge (e.g., border) 311e (see FIG. 8) of the first surface 311 of the first printed circuit board 310 or an edge 321e (see FIG. 9) of the third surface 321 of the second printed circuit board 320. As an example, the interposer 330 may extend along a portion of the edge 311e (see FIG. 8) of the first surface 311 or the edge 321e (see FIG. 9) of the third surface 321, and may form the inside space 331 together with a structure (not illustrated) protruding from the edge 311e (see FIG. 8) of the first surface 311 or the edge 321e (see FIG. 9) of the third surface 321. As another example, the interposer 330 may extend along the edge 311e (see FIG. 8) of the first surface 311 or the edge 321e (see FIG. 9) of the third surface 321 to form the inside space 331.

According to an embodiment of the disclosure, the electronic device 101 may include an electronic component E1. As an example, the electronic component E1 may include an application processor. The electronic component E1 may be mounted on the fourth surface 322 of the second printed circuit board 320. In other words, the electronic component E1 may be mounted on the fourth surface 322 that is opposite to the third surface 321 facing the inner space 331, such that the electronic component E1 is located, or disposed, outside of the inner space 331.During the operation of the electronic component E1, heat may be generated, and the generated heat may be transferred to the third surface 321 of the second printed circuit board 320.

According to an embodiment of the disclosure, the electronic device 101 may include at least one shield can (e.g. shielding elements or members) 341 and/or 344. That is, in examples, the electronic device 101 may comprise one or more shield cans (e.g., at least one shield can). The shield cans 341 and 344 may be mounted on (e.g., disposed on) the first surface 311 of the first printed circuit board 310. Components 342 and 345 (e.g., a GPS) may be disposed inside the shield cans 341 and 344. In examples, at least one component may be disposed inside each of the shield cans 341 and 344, such as at least one component 342 may be disposed inside the shield can 341, and at least one component 345 may be disposed inside the shield can 344. The shield cans 341 and 344 may be connected to (e.g., mounted on) the first printed circuit board 310. In other words, the components 342 and 345 may be shielded from inside space 331 by at least one of shield cans 341 and 344. The shield cans 341 and 344 illustrated in FIG. 5 may be referred to as a first shield can 341 and a second shield can 344, respectively, and may be applied identically to the same reference numerals.

According to an embodiment of the disclosure, the inside space 331 may include a first area 331a and a second area 331b. The first area 331a may be understood as an interstice (e.g., a first intervening space) between the first surface 311 of the first printed circuit board 310 on which the shield cans 341 and 344 are not disposed, and the third surface 321 of the second printed circuit board 320 facing the first surface. The second area 331b may be understood as an interstice (e.g., a second intervening space) between the top surfaces 341s and 344s of the shield cans 341 and 344 and the third surface 321. The second area 331b may include a space between the top surface 341s of the first shield can 341 and an area of the third surface 321 facing the top surface 341s, and a space between the top surface 344s of the second shield can 344 and an area of the third surface 321 facing the top surface 344s.

The gap G2 between the top surface 341s and 344s of the shield cans 341 and 344 facing the third surface 321 of the second printed circuit board and the third surface 321 may be smaller than the gap G1 between the first surface 311 of the first printed circuit board 310 and the third surface 321. An interstice (e.g., a second area 331b of the side space 331) having a width (e.g., the gap G2 between the top surfaces 341s and 344s of the shield cans 341 and 344 and the third surface 321) smaller than the width (e.g., the gap G1 between the first surface S11 and the third surface 321) of the first area 331a of the inside space 331 may be formed between the shield cans 341 and 344 and the third surface 321.

According to an embodiment of the disclosure, the shield cans 341 and 344 may protrude from the first surface 311 of the first printed circuit board 310 toward the third surface 321 of the second printed circuit board 320. The shield cans 341 and 344 may be disposed in the inside space 331. The volume of the inside space 331 in which the heat dissipation material 350 is disposed may be reduced by the shield cans 341 and 344. That is, in examples, a total area of the inside space 331 into which the heat dissipation material 350 may be disposed may be reduced in view of the area formed within each shield can 341, 344.

According to an embodiment of the disclosure, the electronic device 101 may include a heat dissipation material 350. The heat dissipation material 350 may be disposed in the inside space 331. For example, the heat dissipation material 350 may be disposed between the third surface 321 of the second printed circuit board 320 and the shield cans 341 and 344. The heat dissipation material 350 may be in contact with (e.g., may be in contact with at least a portion of) the third surface 321 of the second printed circuit board. The heat dissipation material 350 may absorb heat generated from the electronic component E1 through the third surface 321.

According to an embodiment of the disclosure, the heat dissipation material 350 may have a viscosity within a predetermined range. The heat dissipation material 350 may not flow with a large displacement in the inside space 331 due to viscosity even when an external force is applied to the electronic device 101. The heat dissipation material 350 may be understood as a gel-like material in that it has high viscosity unlike a liquid and thus does not flow with a large displacement in the inside space 331. As an example, the heat dissipation material may include heat dissipation particles (e.g., Al₂O₃ and/or AlN), additives (curing agents, catalysts, and the like), silicone resins, silicone oils, and the like.

According to an embodiment of the disclosure, the heat dissipation material 350 may include a first portion 351 disposed between the top surfaces 341s and 344s of the shield cans 341 and 344 and the third surface 321 of the second printed circuit board 320. Herein, the top surfaces 341s and 344s may define a surface of the shield can 341 or 344 that faces inwards (e.g., toward inside space 331, and facing toward the third surface 321 of the second printed circuit board 320). The heat dissipation material 350 may be stably disposed between the top surfaces 341s and 344s of the shield cans 341 and 344 and the third surface 321 of the second printed circuit board 320 by the shield cans 341 and 344. Therefore, the heat dissipation material 350 may be stably disposed in one area of the inside space 331 through the shield cans 341 and 344, and the amount of the heat dissipation material 350 disposed in the inside space 331 may be minimized and/or reduced.

According to an embodiment of the disclosure, the heat dissipation material 350 may include a second portion 352 disposed between the first surface 311 of the first printed circuit board 310 and the third surface 321 of the second printed circuit board 320. The second portion 352 of the heat dissipation material 350 may include a portion disposed between the third surface 321 and an area of the first surface 311 where the shield cans 341 and 344 are not disposed.

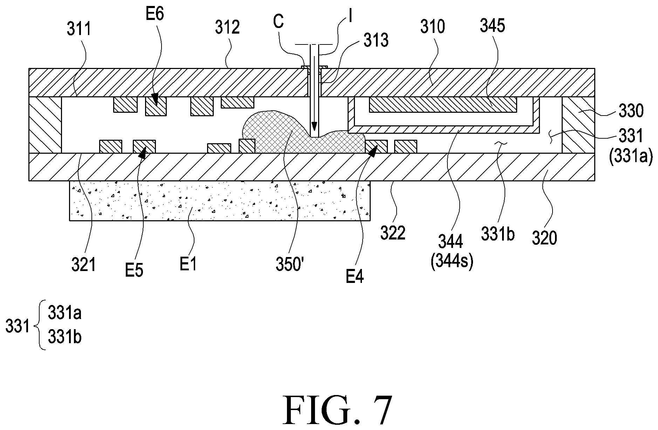

According to an embodiment of the disclosure, the electronic device 101 may include a through hole 313 disposed at (e.g., through, within) the first printed circuit board 310. The through hole 313 may penetrate the first surface 311 and the second surface 312 of the first printed circuit board 310. The through hole 313 may be disposed outside the shield cans 341 and 344. The through hole 313 may be disposed adjacent to the shield cans 341 and 344 . That is, in examples, the through hole 313 may be disposed (or extend) through the first surface 311 between shield cans 341 and 344. The at least one shield can (341, 344) may partially surround the through hole 313 (e.g., may be arranged adjacent to at least a portion of the edge/circumference of the through hole 313). The through hole 313 may be open toward the inside space 331. The through hole 313 will be described in detail with reference to FIG. 7.

According to an embodiment of the disclosure, the electronic device 101 may include a cap C. The cap C may cover the through hole 313. The cap C may be disposed on the second surface 312 of the first printed circuit board 310. As an example, the cap C may include a plurality of slits.

According to an embodiment of the disclosure, the electronic device 101 may further include a plurality of mounting components E3, E4, E5, and E6. The plurality of mounting components E3, E4, E5, and E6 may be mounted on the first printed circuit board 310 and/or the second printed circuit board 320. The plurality of mounting components E3, E4, E5, and E6 may be mounted on the first surface 311 and/or the second surface 312 of a first printed circuit board 310. The plurality of mounting components E3, E4, E5, and E6 may be mounted on the third surface 321 and/or the fourth surface 322 of the second printed circuit board 320. As an example, the plurality of mounting components E3, E4, E5, and E6 may include, but are not limited to, power control components (e.g., a power management integrated circuit), communication components (e.g., a radio frequency integrated circuit or an intermediate frequency integrated circuit), or electrical components such as a capacitor.

According to an embodiment of the disclosure, the plurality of mounting components E3, E4, E5, and E6 may include a first mounting component E3. The first mounting component E3 may be positioned between the top surface 341s of the first shield can 341 and the third surface 321 of the second printed circuit board 320. The first mounting component E3 may be mounted on an area of the third surface 321 facing the top surface 341s of the first shield can 341.

According to an embodiment of the disclosure, the plurality of mounting components E3, E4, E5, and E6 may include a second mounting component E4. The second mounting component E4 may be positioned between the top surface 344s of the second shield can 344 and the third surface 321 of the second printed circuit board 320. The second mounting component E4 may be mounted on an area of the third surface 321 facing the top surface 344s of the second shield can 344.

According to an embodiment of the disclosure, the plurality of mounting components E3, E4, E5, and E6 may include a third mounting component E5. The third mounting component E5 may be mounted on an area of the third surface 321 of the second printed circuit board 320 that does not face the top surfaces 341s and 344s of the shield cans 341 and 344. The plurality of mounting components E3, E4, E5, and E6 may include a fourth mounting component E6. The fourth mounting component E6 may be mounted on an area of the first surface 311 of the first printed circuit board 310 where the shield cans 341 and 344 are not disposed.

FIG. 7 is a view illustrating how a heat dissipation material 350unting components E3, E4, E5, and E6 may include a third mounting component E5. The third mounting component E5 may be mounted on an area of the third surface 321closure. According to an embodiment of the disclosure, the heat dissipation material 350' may be injected into the inside space 331 through a through hole 313. The heat dissipation material 350' may be injected into the inside space 331 through an injector I. However, the method of placing the heat dissipation material 350' in the inside space 331 is not limited thereto, and in another embodiment, the heat dissipation material 350' may be placed in the inside space 331 by applying the heat dissipation material 350' on the third surface 321 and then covering the first printed circuit board 310 on which the shield cans 341 and 344 are mounted.

According to an embodiment of the disclosure, the injector I may be inserted into the inside space 331 by passing through the slit and the through hole 313 of the cap C in a sequential order. The heat dissipation material 350 through the slit and the through hole 313 of the cap C space 331 by passing t third mounting component E5. The third mouninto the inside space 331 along the third surface 321 of the second printed circuit board 320. The spreading speed of the heat dissipation material 350' may be reduced as the heat dissipation material collides with the shield cans 341 and 344, the components mounted on the first surface 311 of the first printed circuit board 310 or the components mounted on the third surface 321 of the second printed circuit board 320 while spreading out into the inside space 331 based on the injector I.

According to an embodiment of the disclosure, the speed at which the heat dissipation material 350' spreads when passing through a narrow interstice (e.g., the second area 331b of the inside space 331) between the shield cans 341 and 344 and the third surface 321 may be smaller than the speed at which the heat dissipation material 350') spreads when passing through the space between the first surface 311 and the third surface 321. Accordingly, the approximate distribution of the heat dissipation material 350' injected into the inside space 331 may be controlled through the arrangement of the shield cans 341 and 344.

According to an embodiment of the disclosure, the heat dissipation material 350pation material 350' spreads when passing tthrough the through hole 313 may include a case where the heat dissipation material 350' is injected into the inside space 331 by directly passing through the through hole 313. In addition, the heat dissipation material 350' being injected into the inside space 331 through the through hole 313 may include a case where the injector I is inserted into the internal space 331 through the through hole 313, and then the heat dissipation material 350' is injected into the inside space 331 through the inserted injector I.

FIG. 8 is a view illustrating the distribution of the heat dissipation material 350 on a first printed circuit board 310, according to an embodiment of the disclosure. FIG. 9 is a view illustrating the distribution of a heat dissipation material 350 on the second printed circuit board 320, according to an embodiment of the disclosure.

Referring to FIGS. 8 and 9, the interposer 330 according to an embodiment of the disclosure may extend on the first printed circuit board 310. For example, the interposer 330 may extend along the edge 311e of the first printed circuit board 310. A plurality of vias connected to the interposer 330 may be disposed outside of the edge 311b.

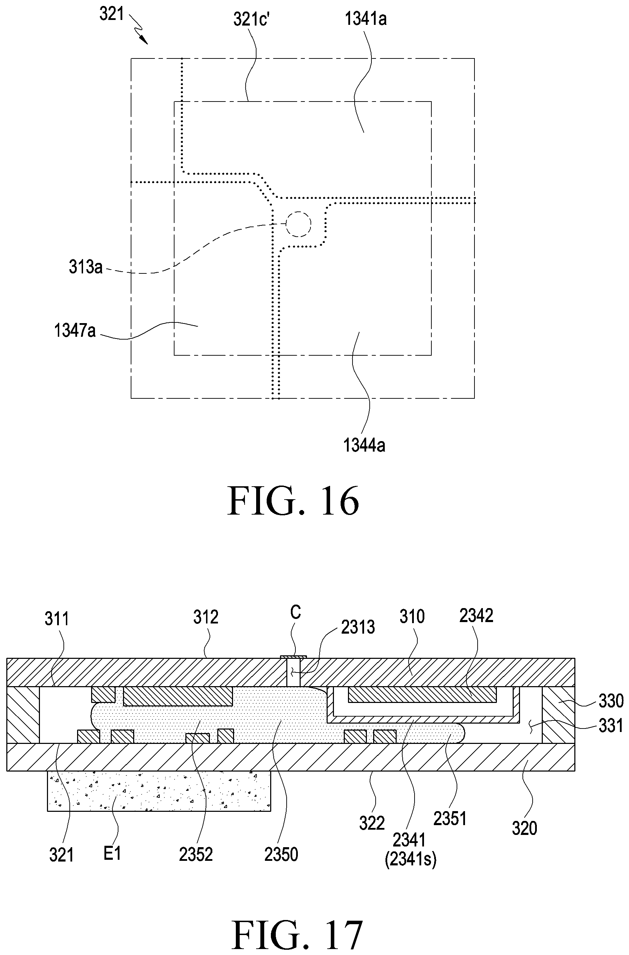

According to various embodiments of the disclosure, the electronic device 101 may include one or more shield cans 341, 344, and 347. According to an embodiment of the disclosure, the electronic device 101 may include a plurality (e.g., three) of shield cans 341, 344, and 347, as illustrated in FIG. 8. According to another embodiment of the disclosure (e.g., see FIG. 17), the electronic device 101 may include a single shield can, unlike that illustrated in FIG. 8.

According to an embodiment of the disclosure, the plurality of shield cans 341, 344, and 347 may be disposed adjacent to the through hole 313. For example, the gaps between the plurality of shield cans 341, 344, and 347 and the through hole 313 may be 1 mm to 2 mm. The plurality of shield cans 341, 344, and 347 may be arranged along the border of the through hole 313 to at least partially surround the through hole 313 (e.g., may be arranged adjacent to at least a portion of the edge/circumference of the through hole 313).

According to an embodiment of the disclosure, the third surface 321 of the second printed circuit board 320 may include a first area 321c. The first area 321c is an area corresponding to the electronic component E1, and may include, for example, an area overlapping with the electronic component E1 when viewed from above the third side 321. The first area 321c may include an area opposite an area of the fourth surface 322 on which an electronic component E1 is mounted.

According to an embodiment of the disclosure, the third surface 321 of the second printed circuit board 320 may include core areas B1 and B2. The core areas B1 and B2 may correspond to a high heat-generating area in the electronic component E1, such as an area corresponding to a processing core of a processor (e.g., the processor 120 in FIG. 1).

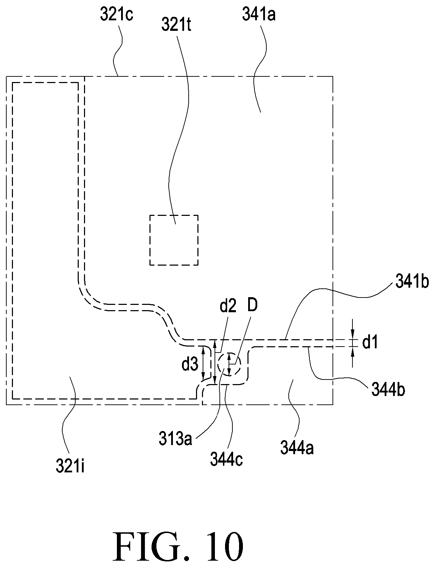

According to an embodiment of the disclosure, the third surface 321 of the second printed circuit board 320 may include a third area 313a. The first area 321c is an area corresponding to the electronic component E1, and may include, for example, an area overlapping with the through hole 313 when viewed from above the third side 321. It may be understood that the heat dissipation material 350 spreads out radially based on the third area 313a corresponding to the through hole 313. The first area 321c, the core areas B1 and B2, and the third area 313a will be described in detail with reference to FIGS. 9 and 10.

FIG. 10 is a view illustrating a plurality of areas projected onto the second printed circuit board according to an embodiment of the disclosure.

Referring to FIGS. 9 and 10, the third surface 321 of the second printed circuit board 320 according to an embodiment of the disclosure may include second areas 341a and 344a (e.g. a plurality of second areas) facing the top surfaces (341s and 344s in FIG. 8) of the shield cans 341 and 344. That is, a second area 341a (of the plurality of second areas) may correspond to an area facing shield can 341 (the top surface 341s thereof), , and second area 344a may correspond to an area facing shield can 344 (the top surface 344s thereof). The second areas 341a and 344a may at least partially overlap with the first area 321c. The second areas 341a and 344a may include an area overlapping with the shield cans 341 and 344 when viewed from above the third surface 321.

According to an embodiment of the disclosure, the third surface 321 of the second printed circuit board 320 may include the fourth area 321i located inside the first area 321c. The fourth area 321i may not overlap with the second areas 341a and 344a. The fourth area 321i may face an area of the first surface 311 (see FIG. 8) of the first printed circuit board 310 where the shield cans 341 and 344 are not disposed. The fourth area 321i may surround the third area 313a together with the second areas 341a and 344a. The fourth area 321i may extend from a side of the third area 313a toward the border of the first area 321c.

According to an embodiment of the disclosure, the third area 313a may be located inside the first area 321c. When viewed from above the third surface 321 of the second printed circuit board 320, the through hole 313 may be covered by the electronic component E1. Therefore, the heat dissipation material 350 injected into the internal space 331 through the through hole 313 may move to the third surface 321 of the second printed circuit board 320 and may spread out in the radial direction (see FIGS. 8 and 9) based on the third area 313a.

According to an embodiment of the disclosure, the third area 313a may be spaced apart from the central portion 321t of the first area 321c. For example, the third area 313a may be positioned closer to one side of the edge rather than to the center of the first area 321c. In this case, the heat dissipation material 350 injected through the through hole 313 may not evenly spread over the first area 321c. In addition, in order to bring the heat dissipation material 350 into contact with either the entire first area 321c or an area separated from the third area 313a (e.g., the core areas B1 and B2), a large amount of the heat dissipation material 350 needs to be injected.

According to an embodiment of the disclosure, the heat dissipation material 350 injected through the through hole 313 may spread radially based on the third area 313a. The heat dissipation material 350, which spreads in the radial direction based on the third area 313a, may spread along the second areas 341a and 344a and the fourth area 321i. The speed at which the heat dissipation material 350 spreads along the second areas 341a and 344a may be lower than the speed at which the heat dissipation material spreads along the fourth area 321i. Therefore, the heat dissipation material 350 may spread farther from the third area 313a when it spreads along the fourth area 321i compared to when it spreads along the second areas 341a and 344a. In addition, the heat dissipation material 350 can be controlled to spread to areas requiring heat dissipation (e.g., the core areas B1 and B2). Therefore, the amount of heat dissipation material 350 used to increase the area covering the third area 313a and the first area 321c may be minimized and/or reduced.

According to an embodiment of the disclosure, the second areas 341a and 344a may include edges 341b, 344b, and 344c corresponding to the side surface of the shield cans 341 and 344. The first edge 341b and the second edge 344b adjacent to each other may extend substantially parallel to each other. In examples, the first edge 341b and second edge 344b, may correspond to adjacent side surfaces of respective shield cans (341, 344) that are next to (adjacent to) each other. The first edge 341b and the second edge 344b may be spaced apart from each other by a first distance d1.

According to an embodiment of the disclosure, the third area 313a may be disposed between the first edge 341b and the third edge 344c. The first edge 341b and the third edge 344c may extend substantially parallel to each other. The first edge 341b and the third edge 344c may be spaced apart from each other by a second distance d2. The second distance d2 may be greater than the first distance d1.

According to an embodiment of the disclosure, the third area 313a corresponding to the through hole 313 may have a predetermined diameter D. The diameter D of the third area 313a may be greater than the first distance d1. The diameter D of the third area 313a may be smaller than the second distance d2.

According to an embodiment of the disclosure, one end of the fourth area 321i adjacent to the third area 313a may have a predetermined width d3. The width d3 of the one end of the fourth area 321i may be greater than the distance d1 between two adjacent shield cans 341 and 344 among the plurality of shield cans 341, 344, and 347. The width d3 of the one end of the fourth area 321i may be equal to or greater than the diameter D of the third area 313a.

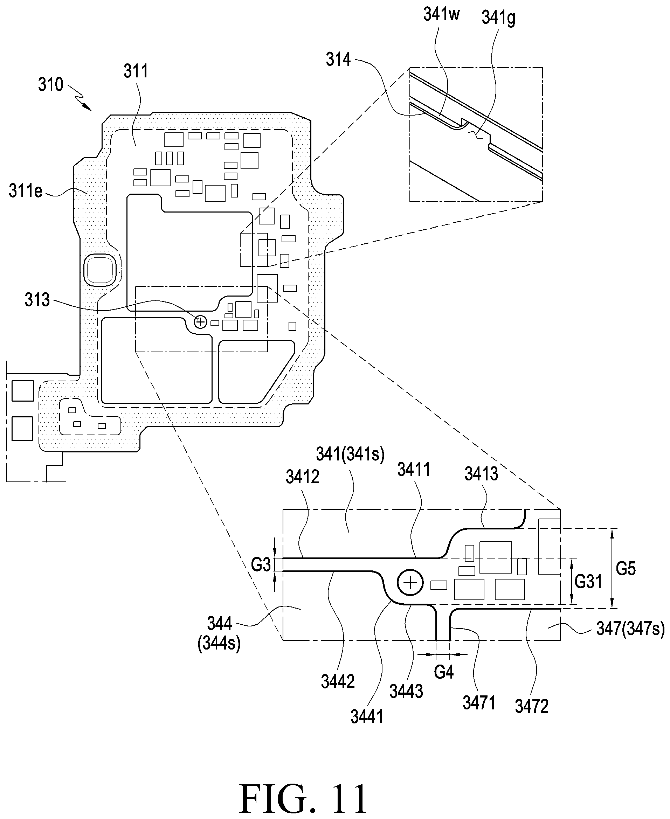

FIG. 11 is a view illustrating the arrangement of a plurality of shield cans 341, 344, and 347 and a through hole 313 according to an embodiment of the disclosure.

Referring to FIG. 11, the plurality of shield cans 341, 344, and 347 according to an embodiment of the disclosure may be arranged to at least partially surround the through hole 313. The plurality of shield cans 341, 344, and 347 may be positioned adjacent to each other. According to another embodiment of the disclosure (e.g., see FIG. 17), unlike that illustrated in FIG. 11, the electronic device 101 may include at least one (e.g., one or two) shield can (not illustrated) arranged to at least partially surround the through hole 313. The number and shape of shield cans are not limited to various embodiments of the disclosure, and may include a case where at least some (e.g., the first shield can 341 and the second shield can 344) of the plurality of shield cans 341, 344, and 347 illustrated in FIG. 11 are formed integrally.

According to an embodiment of the disclosure, the first shield can 341 may include a base portion 341w that is in contact with a conductive pad 314 disposed on the first surface 311 of the first printed circuit board 310. A solder cream may be applied between the conductive pad 314 and the base portion 341w. The first shield can 341 may include a plurality of base portions 341w, and a recess 341g may be formed between the base portions 341w. The interior and exterior of the first shield can 341 may be spatially connected through the recess 341g.

According to an embodiment of the disclosure, the first shield can 341 may include a first side portion 3411 that partially surrounds the through hole 313. The first shield can 341 may include a second side portion 3412 that extends from the first side portion 3411 and is adjacent to the second shield can 344. The first shield can 341 may include a third side portion 3413 that extends from the first side portion 3411 and is disposed farther from the through hole 313 than the first side portion 3411.

According to an embodiment of the disclosure, the second shield can 344 may include a first side portion 3441 that partially surrounds the through hole 313. The first side portion 3441 may be partially bent along the through hole 313. The second shield can 344 may include a second side portion 3442 that extends from the first side portion 3441 and is adjacent to the first shield can 341. The second shield can 344 may include a third side portion 3443 that extends from the first side portion 3441 and is disposed farther from the through hole 313 than the first side portion 3441.

According to an embodiment of the disclosure, the third shield can 347 may include a first side portion 3471 adjacent to the third side portion 3443 of the second shield can 344. The third shield can 347 may include a second side portion 3472 extending from the first side portion 3441 away from the through hole 313.

According to an embodiment of the disclosure, the second side portion 3412 of the first shield can 341 may extend along the second side portion 3442 of the second shield can 344. The first side portion 3411 of the first shield can 341 and the first side portion 3441 of the second shield can 344 may extend to surround the through hole 313. The gap G3 between the second side portion 3412 of the first shield can 341 and the second side portion 3442 of the second shield can 344 may be smaller than the gap G31 between the first side portion 3411 of the first shield can 341 and the first side portion 3441 of the second shield can 344.

According to an embodiment of the disclosure, the third side portion 3413 of the first shield can 341 may extend along the second side portion 3472 of the third shield can 347. The third side portion 3413 of the first shield can 341 and the second side portion 3472 of the third shield can 347 may be spaced apart from each other by a predetermined gap G5. The gap G5 between the third side portion 3413 of the first shield can 341 and the second side portion 3472 of the third shield can 344 may be greater than the gap G31 between the first side portion 3411 of the first shield can 341 and the first side portion 3441 of the second shield can 344. Therefore, the heat dissipation material may flow smoothly.

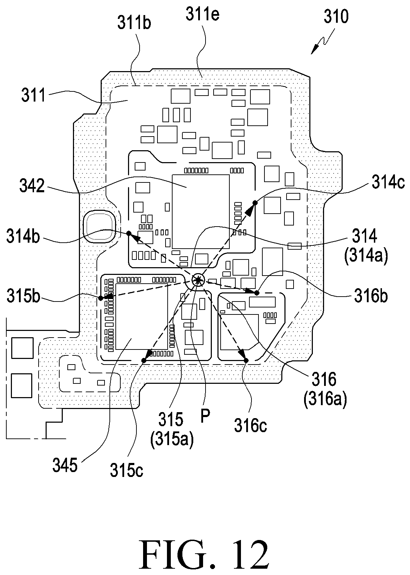

FIG. 12 illustrates a state in which the shield cans 341, 344, and 347 are removed from FIG. 11 according to an embodiment of the disclosure.

According to an embodiment of the disclosure, the electronic device 101 may include a plurality of conductive pads 314, 315, and 316. The conductive pads 314, 315, and 316 may be disposed on the first surface 311 of a first printed circuit board 310. The first shield can 341 may be disposed on the first conductive pad 314. The second shield can 344 may be disposed on the second conductive pad 315. The third shield can 347 may be disposed on the third conductive pad 316.

According to an embodiment of the disclosure, the electronic device 101 may include a plurality of first conductive pads 314. The plurality of first conductive pads 314 may be arranged to form a predetermined first loop. The predetermined first loop formed by the plurality of first conductive pads 314 may correspond to an edge of the first shield can 341. The first shield can 341 may be disposed on the plurality of first conductive pads 314.

According to an embodiment of the disclosure, the electronic device 101 may include a plurality of second conductive pads 315. The plurality of second conductive pads 315 may be arranged to form a predetermined second loop. The predetermined second loop formed by the plurality of first conductive pads 315 may correspond to an edge of the second shield can 344. The second shield can 344 may be disposed on the plurality of second conductive pads 315.

According to an embodiment of the disclosure, the electronic device 101 may include a plurality of third conductive pads 316. The plurality of third conductive pads 316 may be arranged to form a predetermined third loop. The predetermined third loop formed by the plurality of third conductive pads 316 may correspond to an edge of the third shield can 347. The third shield can 347 may be disposed on the plurality of third conductive pads 316.

According to an embodiment of the disclosure, the number of conductive pads 314, 315, and 316 is not limited to the embodiment illustrated in FIG. 12. According to various embodiments of the disclosure, the plurality of first conductive pads 314, the plurality of second conductive pads 315, or the plurality of third conductive pads 316 may be formed of at least one (e.g., one or two) conductive pad, unlike that illustrated in FIG. 12.

According to an embodiment of the disclosure, some 314a of the first conductive pads 314 and some 315a of the second conductive pads 315 may extend to partially surround the through hole 313. The heat dissipation material 350 introduced into the inside space 331 through the through hole 313 may spread along the outer surfaces of the plurality of shield cans 341, 344, and 347.

According to an embodiment of the disclosure, both ends 314b and 314c of the first conductive pads 314 may be spaced apart from the center P of the through hole 313. Both ends 315b and 315c of the second conductive pads 315 may be spaced apart from the center P of the through hole 313. Both ends 316b and 316c of the third conductive pads 316 may be spaced apart from the center P of the through hole 313. The recesses 341g (see FIG. 11) of the shield cans 341, 344, and 347 may be disposed at both ends 314b and 314c, 315b and 315c, and 316b and 316c of the conductive pads 314, 315, and 316.

According to an embodiment of the disclosure, the distance from the center P of both ends 314b and 314c, 315b and 315c, and 316b and 316c of the conductive pads 314, 315, and 316 from the center P of the through hole 313 may be determined by factors that are involved in the extent to which the heat dissipation material 350 spreads, such as the injection amount of the heat dissipating material 350, and the positions of the shield cans 341, 344, and 347. As an example, the distance of both ends 314b and 314c, 315b and 315c, and 316b and 316c of the conductive pads 314, 315, and 316 from the center P of the through hole 313 may be 20 mm to 30 mm.

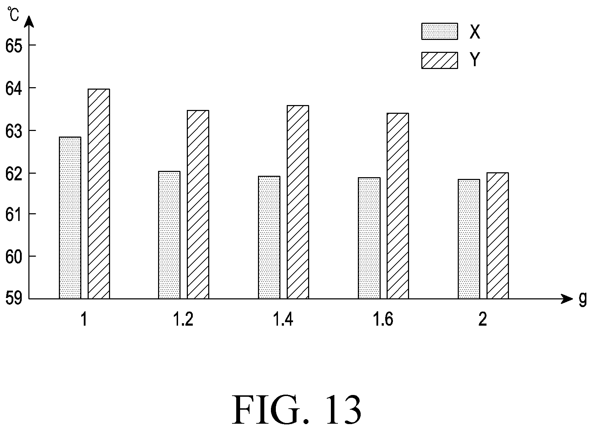

FIG. 13 is a graph showing the temperature of an electronic component E1 depending on the amount of an injected heat dissipation material 350 according to an embodiment of the disclosure. The temperature of the electronic component E1 may be understood as the temperature of the electronic component E1 measured based on the time when the electronic component E1 exhibits maximum performance. Y represents the temperature when the shield cans 341, 344, and 347 are not disposed in the inside space 331 unlike those in the embodiment of the disclosure, and X represents the temperature when the shield cans 341, 344, and 347 are disposed in the internal space 331 as in the embodiment of the disclosure. As an example, the temperature of the electronic component E1 can be calculated using values measured by a plurality of thermometers (not illustrated) included in the electronic component E1.

Referring to FIG. 13, when the shield cans 341, 344, and 347 are not disposed in the inside space 331 unlike those in the embodiment of the disclosure (Y), the temperature of the electronic component E1 becomes an appropriate temperature (e.g., 62 degrees Celsius) when 2 g of heat dissipation material 350 is injected. However, when the shield cans 341, 344, and 347 are not disposed in the inside space 331 as in the embodiment of the disclosure (X), it may be seen that the temperature of the electronic component E1 is at the appropriate temperature even when only 1.4 g of heat dissipation material 350 is injected.

According to an embodiment of the disclosure, when the shield cans 341, 344, and 347 are disposed, the heat dissipation material 350 is stably disposed at an area (e.g., the first area 321c) of the third surface 321 where heat may be effectively dissipated from the electronic component E1, thereby ensuring the heat dissipation performance of the electronic component E1 even with a smaller amount of heat dissipation material 350.

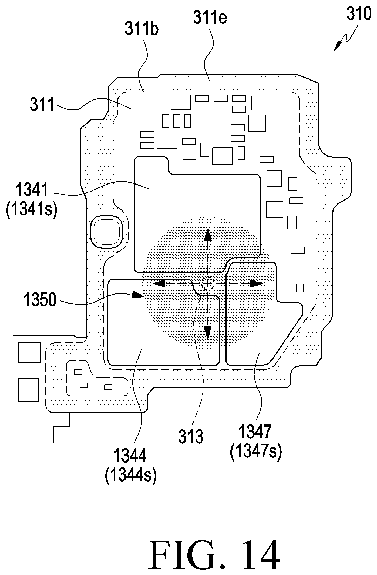

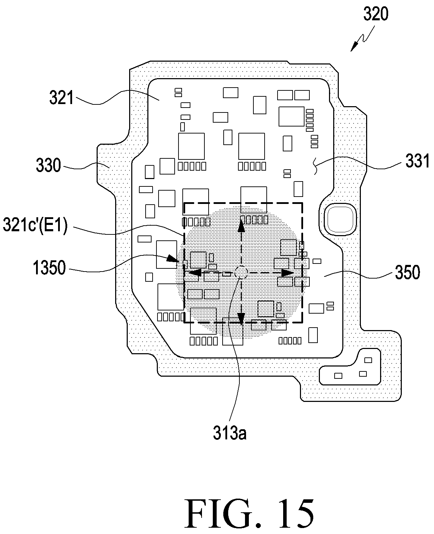

FIG. 14 illustrates the position of a heat dissipation material 1350 on the first printed circuit board 310 according to an embodiment of the disclosure. FIG. 15 illustrates the position of a heat dissipation material 1350 on the second printed circuit board 320 according to an embodiment of the disclosure. FIG. 16 illustrates a plurality of areas projected onto the second printed circuit board according to an embodiment of the disclosure.

The description of components described with reference to FIGS. 2 to 13 (e.g., the heat dissipation material 350, the plurality of shield cans 341, 344, and 347, the first area 321c, and the second areas 341a, 344a, and 347a) may be substantially identically applied to components of the same names illustrated in FIGS. 14 to 16 (e.g., the heat dissipation material 1350, the plurality of shield cans 1341, 1344, and 1347, the first area 321c', and the second areas 1341a, 1344a, and 1347a) to the extent that they do not contradict each other.

Referring to FIGS. 14 to 16, the plurality of shield cans 1341, 1344, and 1347 may surround the through hole 313. The heat dissipation material 1350 injected into the inside space 331 through the through hole 313 may spread in the radial direction based on the through hole 313. The injected heat dissipation material 1350 may be disposed between the plurality of shield cans 1341, 1344, and 1347 and the third surface 321 of the second printed circuit board 320.

According to an embodiment of the disclosure, the third surface 321 of the second printed circuit board 320 may include a first area 321c' corresponding to an electronic component E1. When viewed from above the third surface 321, the first area 321c' may include an area overlapping with the electronic component E1. The third surface 321 may include second areas 1341a, 1344a, and 1347a facing the top surfaces 1341s, 1344s, and 1347s of the plurality of shield cans 1341, 1344, and 1347. When viewed from above the third surface 321, the second areas 1341a, 1344a, and 1347a may include an area overlapping with the top surfaces 1341s, 1344s, and 1347s of the plurality of shield cans 1341, 1344, and 1347.

According to an embodiment of the disclosure, the through hole 1313 may be covered by the electronic component E1 when viewed from above the fourth surface 322. When viewed from above the third surface 321, the third area 1313a may be disposed inside the first area 321c electronic component E1 when viewed from above the fourth surface 322. When viewed fdisposed at the central portion of the first area 321cponent E1 when viewed from above tin FIG. 10).

According to an embodiment of the disclosure, the second areas 1341a, 1344a, and 1347a corresponding to the plurality of shield cans 1341, 1344, and 1347 may surround the third area 313a. The heat dissipation material 350 introduced into the inside space 331 through the through hole 313 may spread along the second areas 1341a, 1344a, and 1347a of the third surface 321 and may be stably disposed between the plurality of shield cans 1341, 1344, and 1347 and the third surface 321.

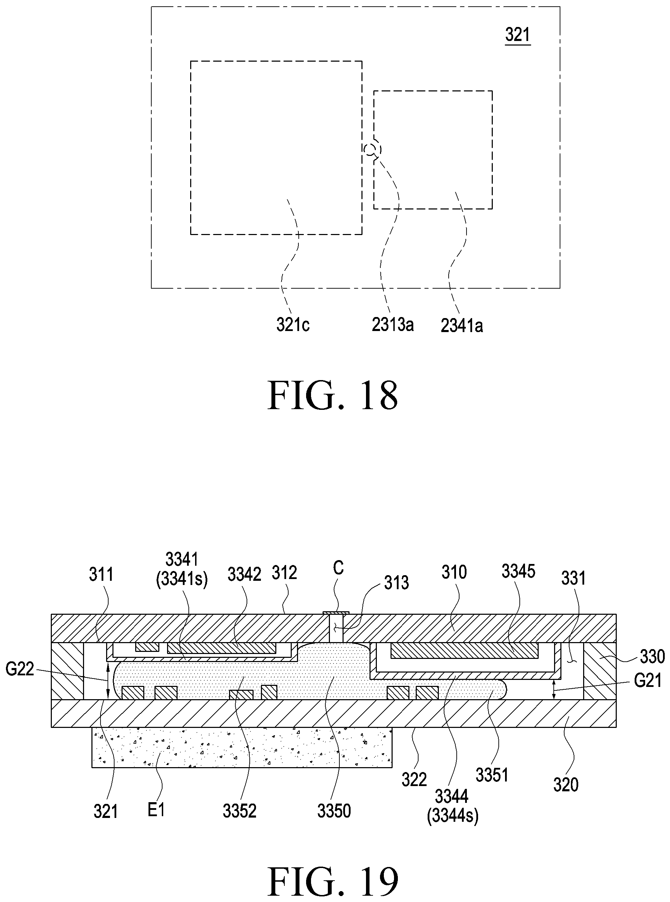

FIG. 17 illustrates a shield can 2341 and a heat dissipation material 2350, according to an embodiment of the disclosure. FIG. 18 illustrates a plurality of areas 321c, 2313a, and 2341a on a second printed circuit board 320, according to an embodiment of the disclosure.

The description of components described with reference to FIGS. 2 to 13 (e.g., the heat dissipation material 350, the shield cans 341, 344, and 347, the second areas 313a, 344a, and 347a, the third area 313a, and the through hole 313) may be substantially identically applied to components of the same names illustrated in FIGS. 17 and 18 (e.g., the heat dissipation material 1350, the plurality of shield cans 1341, 1344, and 1347, the first area 321c', the second area 2341a, the third area 2313a, and the through hole 2313) to the extent that they do not contradict each other.

Referring to FIGS. 17 and 18, according to an embodiment of the disclosure, the third surface 321 of the second printed circuit board 320 may include the second area 2341a corresponding to the shield can 2341. The second area 2341a may include an area of the third surface 321 facing the top surface 2341s of the shield can 2341. The second area 2341a may be disposed outside the first area 321c. The second area 2341a may be spaced apart from the first area 321c.

According to an embodiment of the disclosure, the third surface 321 of the second printed circuit board 320 may include a third area 2313a corresponding to the through hole 2313. The third area 2313a may face the through hole 2313. The third area 2313a may be disposed between the second area 2341a and the first area 321c.

According to an embodiment of the disclosure, the heat dissipation material 2350 injected into the inside space 331 through the through hole 2313 may include a first portion 2351 between the shield can 2341 and the second area 2341a. The heat dissipation material 2350 may include a second portion 2352 between the first surface 311 of the first printed circuit board 310 and the first area 321c of the third surface 321.

According to an embodiment of the disclosure, the speed at which the heat dissipation material 2350 spreads toward the second area 2341a based on the through hole 2313 may be lower than the speed at which it spreads toward the first area 321c. Therefore, a larger amount of heat dissipation material 2350 may spread from the through hole 2313 toward the opposite side of the shield can 2341.

FIG. 19 is a cross-sectional view of a portion of an electronic device 101 illustrating a plurality of shield cans 3341 and 3344 according to an embodiment of the disclosure.

The description of components described with reference to FIGS. 2 to 13 (e.g., the heat dissipation material 350, the shield cans 341 and 344) may be substantially identically applied to components of the same names illustrated in FIG. 19 (e.g., the heat dissipation material 3350, the shield cans 1341 and 1344), to the extent that they do not contradict each other.

According to an embodiment of the disclosure, an electronic device 101 may include a plurality of shield cans 3341 and 3344. The plurality of shield cans 3341 and 3344 may at least partially surround a through hole 313. A heat dissipation material 3350 injected into an inside space 331 through the through hole 313 may be introduced between the shield cans 3341 and 3344 and the third surface 321.

According to an embodiment of the disclosure, when viewed from above the fourth surface 322, the through hole 313 may be covered by the electronic component E1. When viewed from above the fourth surface 322, the through hole 313 may be spaced apart from the center of the electronic component E1 (e.g., the central portion 321t in FIG. 10).

In an embodiment of the disclosure, the heights protruding from the first surface 311 of the first printed circuit board 310 may be different from each other. For example, a height of the first shield can 3341 and the second shield can 3344 extending from the first surface 311 into the inside space 331may be different. For example, the gap G22 between the first shield can 3341 (e.g., which may have a smaller height than the second shield can 3344) and the first surface 311 may be smaller than the gap G21 between the second shield can 3344 and the first surface 311.

According to an embodiment of the disclosure, when viewed from above the fourth surface 322, the first shield can 3341 may be positioned closer to the central portion of the electronic component E1 than the second shield can 3344. As an example, when viewed from above the fourth surface 322, the overlapping area of the first shield can 3341 and the electronic component E1 may be greater than the overlapping area of the second shield can 3344 and the electronic component E1.

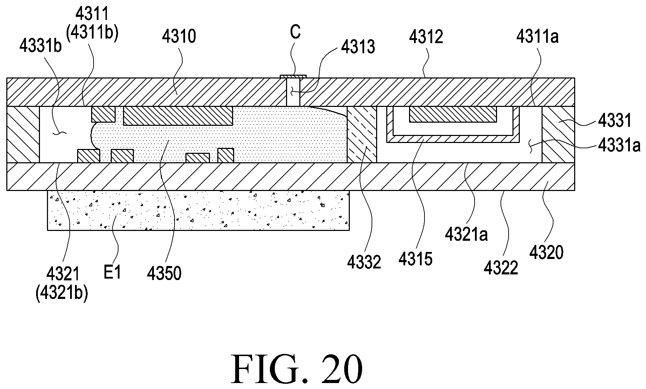

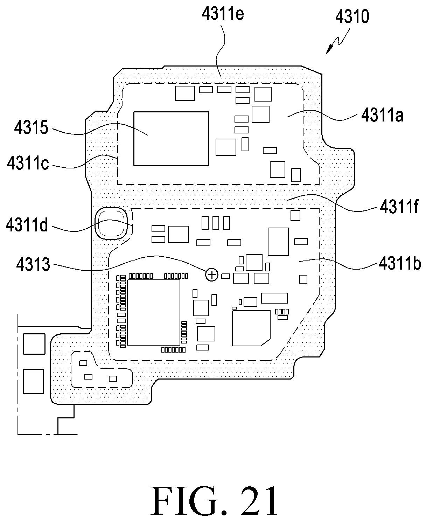

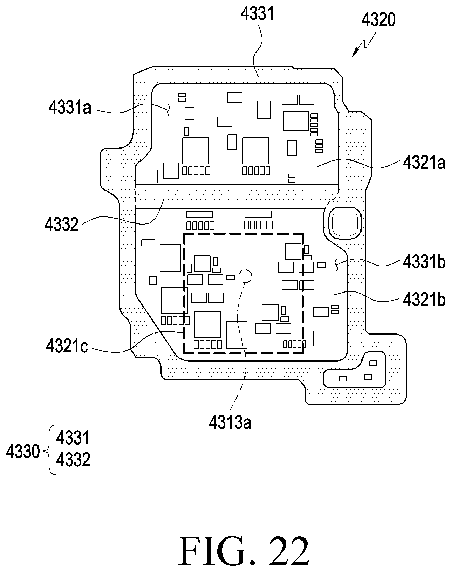

FIG. 20 is a cross-sectional view of a portion of an electronic device 101, illustrating a first interposer 4331 and a second interposer 4332 according to an embodiment of the disclosure. FIG. 21 illustrates a first printed circuit board 4310 according to an embodiment of the disclosure. FIG. 22 illustrates a second printed circuit board 4320 and an interposer 4330 according to an embodiment of the disclosure.

The description of components described with reference to FIGS. 2 to 13 (e.g., the heat dissipation material 350, the first printed circuit board 310, the second printed circuit board 320, the interposer 330, and the through hole 313) may be substantially identically applied to components of the same name illustrated in FIGS. 20 to 22 (e.g., the heat dissipation material 4350, the first printed circuit board 4310, the second printed circuit board 4320, the interposer 4330, and the through hole 4313), to the extent that they do not contradict each other.

Referring to FIGS. 20 to 22, according to an embodiment of the disclosure, an electronic device 101 may include a first printed circuit board 4310 including a first surface 4311 and a second surface 4312 opposite the first surface 4311. The first surface 4311 of the first printed circuit board 4310 may be divided into a first portion 4311a and a second portion 4311b based on a second interposer 4332. A through hole 4313 may be formed at the second portion 4311b of the first surface 4311.

According to an embodiment of the disclosure, the electronic device 101 may include a third surface 4321 facing the first surface 4311 of the first printed circuit board 4310 and a fourth surface 4322 opposite the third surface 4321. The second printed circuit board 4320 may be spaced apart from the first printed circuit board 4310. The third surface 4321 of the second printed circuit board 4320 may be divided into a first portion 4321a and a second portion 4321b based on the second interposer 4332.

According to an embodiment of the disclosure, the second portion 4321b of the third surface 4321 of the second printed circuit board 4320 may include an electronic component area 4321c. The electronic component area 4321c is an area corresponding to the electronic component E1, and may include, for example, an area overlapping with the electronic component E1 when viewed from above the third side 4321. The electronic component area 4321c may include an area of the third surface 4321 opposite to an area of the fourth surface 4322 on which the electronic component E1 is mounted.

According to an embodiment of the disclosure, the second portion 4321b of the third surface 4321 of the second printed circuit board 4320 may include a through hole area 4313a. The through hole area 4313a is an area corresponding to the through hole 4313, and may include, for example, an area overlapping with the through hole 4313 when viewed from above the third surface 4321. The through hole area 4313a may be disposed inside the electronic component area 4321c.

According to an embodiment of the disclosure, the electronic device 101 may include an interposer 4330. The interposer 4330 may be disposed between the first printed circuit board 4310 and the second printed circuit board 4320. In examples, the interposer 4330 may comprise a plurality of interposer portions. The interposer 4330 may include a first interposer 4331 extending along the edge 4321e of the third surface 4321 of the second printed circuit board 4320 to form inside spaces 4331a and 4331b. The interposer 4330 may include a second interposer 4332 disposed in the inside spaces 4331a and 4331b.

According to an embodiment of the disclosure, the second interposer 4332 may be spaced inwardly from the first interposer 4331 (e.g., may be positioned inwardly of the edge 4321e of the third surface 4321 within the inside space 4331). That is, in examples, when the first interposer 4331 extends along an edge of the third surface 4321 of the second printed circuit board 4320, the second interposer 4332 may be spaced inside the first interposer 4331. The second interposer 4332 may be connected to the first interposer 4331. The second interposer 4332 may be connected to the first interposer 4331, and in another embodiment, the second interposer 4332 may be positioned adjacent to the first interposer 4331.

According to an embodiment of the disclosure, the second interposer 4332 may extend across the inside spaces 4331a and 4331b. In examples, the second interposer 4332 may extend across (e.g., divide) the inside space 4331. That is, in examples, the inside spaces 4331a and 4331b may be positioned at each side of the second interposer 4332. The second interposer 4332 may extend along an edge of the electronic component E1 mounted on the fourth surface 4322 of the second printed circuit board 4320. When viewed from above the fourth surface 4322, the second interposer 4332 may partially overlap with the electronic component E1 or may be positioned outside the electronic component E1. By the second interposer 4332, the inside spaces 4331a and 4331b may be partitioned into a first mounting space 4331a and a second mounting space 4331b. That is, a mounting space (e.g., mounting space 4331a and 4331b) may be considered as a space (e.g., inside space 4331a, 4331b) upon which various components may be mounted.

According to an embodiment of the disclosure, a heat dissipation material 4350 may be injected into the second mounting space 4331b through the through hole 4313. Since the heat dissipation material 4350 is not introduced into the first mounting space 4331a by the second interposer 4332, the injection amount of heat dissipation material 4350 for heat dissipation of the electronic component E1 may be minimized and/or reduced.

According to an embodiment of the disclosure, the first printed circuit board 4310 may include interposer mounting portions 4311e and 4311f. The first interposer 4331 may be mounted on a first interposer mounting portion 4311e. The first interposer mounting portion 4311e may form an edge 4311e of the first printed circuit board 4310. The second interposer 4332 may be mounted on a second interposer mounting portion 4311f. The first surface 4311 may be divided into a first area 4311c and a second area 4311d by the second interposer mounting portion 4311f.

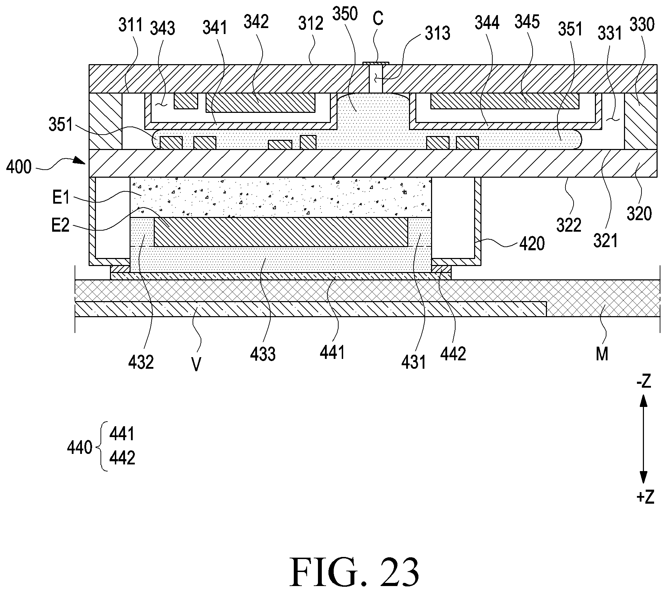

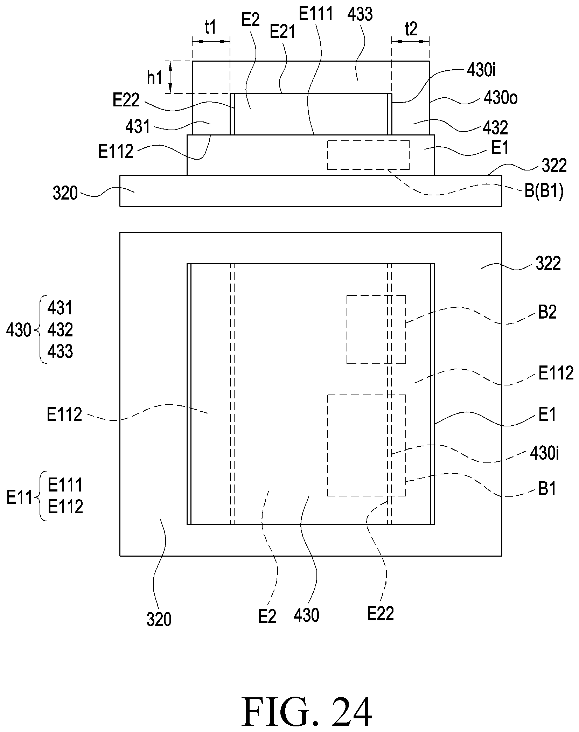

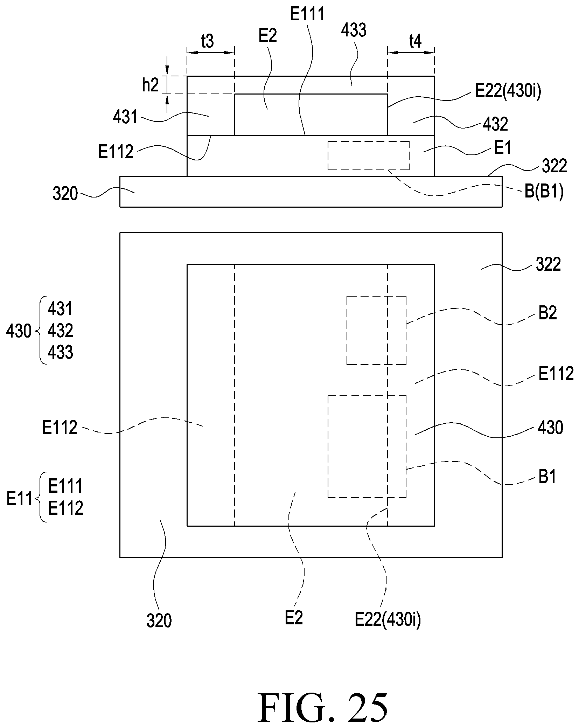

FIG. 23 illustrates a cross-sectional view of a portion of an electronic device 101 according to an embodiment of the disclosure. FIG. 24 illustrates electronic components E1 and E2 and a solid-state heat transfer member 430, which is disposed on the electronic components E1 and E2, as viewed from two directions, according to an embodiment of the disclosure. FIG. 25 illustrates electronic components E1 and E2 and a gel-state heat transfer member 430, which is pressed by a conductive layer 440 (see FIG. 23), as viewed from two directions, according to an embodiment of the disclosure.

Referring to FIGS. 23 to 25, the electronic device 101 according to an embodiment of the disclosure may include a first electronic component E1 and a second electronic component E2 disposed on the first electronic component E1. The second electronic component E2 may be mounted on the first electronic component E1. As an example, the first electronic component E1 may include a processor (e.g., the processor 120 in FIG. 1), and the second electronic component E2 may be memory (e.g., the memory 130 in FIG. 1) mounted on the first electronic component E1 via a solder ball and operatively connected to the first electronic component E1.

According to an embodiment of the disclosure, the electronic device 101 may include a board assembly 400. The description of the substrate assembly 240a described with reference to FIG. 4 may be substantially identically applied to the substrate assembly 400 illustrated in FIG. 23, to the extent that they do not contradict each other. The board assembly 400 may include a heat transfer member 430 (see FIG. 25). The heat transfer member 430 may be in contact with the first electronic component E1 and the second electronic component E2. Heat generated from the first electronic component E1 and the second electronic component E2 may be dissipated to the outside of the electronic device 101 by the heat transfer member 430.

According to an embodiment of the disclosure, the heat transfer member 430 may include a first portion 433 that is in contact with the second electronic component E2. The first portion 433 of the heat transfer member 430 may be disposed between the second electronic component E2 and the first conductive sheet 441. Therefore, the heat from the second electronic component E2 may be dissipated to the first conductive sheet 441 through the first portion 433. In addition, the heat from the first electronic component E1 may be dissipated to the first conductive sheet 441 through the second electronic component E2 and the first portion 433.

According to an embodiment of the disclosure, the heat transfer member 430 may include second portions 431 and 432 that are in contact with the first electronic component E1. Therefore, the heat from the first electronic component E1 may be dissipated from a first surface E11 to the second portions 431 and 432 of the heat transfer member 430. The second portions 431 and 432 of the heat transfer member 430 may extend from the first portion 433 toward the first electronic component E1. As an example, the second portions 431 and 432 may protrude from the edge of the first portion 433 toward the first electronic component E1.

According to an embodiment of the disclosure, the heat transfer member 430 may at least partially cover the second electronic component E2. The second portions 431 and 432 of the heat transfer member 430 may cover at least a portion of a second surface E22 of the second electronic component E2. As an example, the first surface E21 of the second electronic component E2 may be the top surface, and the second surface E22 may be the side surface.

According to an embodiment of the disclosure, the electronic device 101 may include a shield can 420 disposed on the second printed circuit board 320. The shield can 420 may surround the first electronic component E1 and the second electronic component E2. The shield can 420 may be connected to a ground layer (not illustrated) through the printed circuit board 320.

According to an embodiment of the disclosure, the electronic device 101 may include a conductive layer 440 disposed on the shield can 420. As an example, the conductive layer 440 may be in contact with the shield can 420 or may be bonded to the shield can 420 by a conductive adhesive. The conductive layer 440 and the shield can 420 may define a space that may minimize the influence of an external magnetic field. The shield can 420 and the conductive layer 440 may surround the first electronic component E1, the second electronic component E2, and the heat transfer member 430. Therefore, the influence of the external magnetic field on the first electronic component E1 and the second electronic component E2 may be minimized and/or reduced.

According to an embodiment of the disclosure, the conductive layer 440 may include a first conductive sheet 441 disposed on the heat transfer member 430. The first conductive sheet 441 may cover one surface of the heat transfer member 430. For example, the first conductive sheet 441 may be in contact with the one surface of the heat transfer member 430. Therefore, heat may be dissipated from the heat transfer member 430 to the first conductive sheet 441. As an example, the first conductive sheet 441 may be a copper thin-film. The first conductive sheet 441 may be in contact with the metal cover M. The first conductive sheet 441 may be disposed between the heat transfer member 430 and the metal cover M. Therefore, heat may be dissipated from the first conductive sheet 441 to the metal cover M.

According to an embodiment of the disclosure, the conductive layer 440 may be supported by the shield can 420. The conductive layer 440 may include a second conductive sheet 442 interposed between the first conductive sheet 441 and the shield can 420. The second conductive sheet 442 may surround a portion of the heat transfer member 430. For example, the second conductive sheet 442 may be in contact with the side surface of the heat transfer member 430. Therefore, heat may be dissipated from the heat transfer member 430 to the second conductive sheet 442. As an example, the second conductive sheet 442 may be a metal thin-film having a lower thermal conductivity than the first conductive sheet 441.

According to an embodiment of the disclosure, the shield can 420 and the first conductive sheet 441 may be electrically connected through the second conductive sheet 442. Therefore, the first electronic component E1 and the second electronic component E2 may minimize the influence of the external magnetic field through the shield can 420, the second conductive sheet 442, and the first conductive sheet 441.

According to an embodiment of the disclosure, a portion of the heat generated from the first electronic component E1 may be transferred to the heat dissipation material 350 through the second printed circuit board 320. A portion of the heat generated from the first electronic component E1 may be transferred to the heat dispersion member V through the heat transfer member 430. The first electronic component E1 may be positioned between the first shield can 341 and the heat dispersion member V. When viewed from above the fourth surface 322, the first shield can 341 may overlap with the first electronic component E1 or may be covered by the first electronic component E1. For example, the first shield can 341 and the heat dispersion member V may be disposed on opposite sides with respect to the first electronic component E1.

According to an embodiment of the disclosure, the inside space 343 of the first shield can 341 may function as an insulating layer in the process where heat generated from the first electronic component E1 is transferred. The heat generated from the first electronic component E1 may be absorbed by the heat dissipation material 350, but due to the low thermal conductivity of air, the amount transferred to the surface of the electronic device 101 (e.g., the rear surface 210B in FIG. 3) through the air layer may be limited. Accordingly, the surface of the electronic device 101 (e.g., the rear surface 210B in FIG. 3) may be prevented from being locally overheated.

According to an embodiment of the disclosure, the heat dispersion member V may be positioned between the first surface 210A (see FIG. 4) of the electronic device 101 and the first electronic component E1. Therefore, the heat generated from the first electronic component E1 may be transferred to the first surface 210A through the heat dispersion member V. The first shield can 341 may be positioned between the second surface 210B (see FIG. 4) of the electronic device 101 and the first electronic component E1. Therefore, the heat generated from the first electronic component E1 may be transferred to the second surface 210B (see FIG. 4) through the first shield can 341.

According to an embodiment of the disclosure, the heat transfer member 430 can include a phase change material. As an example, the phase change material may include a paraffin series material, which is a temperature-sensitive material. The heat transfer member 430 may be in a solid state at room temperature. The heat transfer member 430 may be at least partially in a gel state at a predetermined temperature or higher. As an example, the predetermined temperature may range from about 45 degrees Celsius to 65 degrees Celsius.

According to an embodiment of the disclosure, the heat transfer member 430 may be in the solid state at room temperature Tr. As an example, the room temperature Tr may be a temperature of 15 degrees Celsius to 25 degrees Celsius. When the heat transfer member 430 is in the solid state, the transport, placement, and assembly of the heat transfer member 430 may be easier compared to when it is the liquid or gel state. In addition, the heat transfer member 430, which has a certain level of rigidity in the solid state, may reduce defects such as dents or indentations of the heat transfer member 430 that may occur during assembly and transportation. Therefore, it is possible to prevent dents or indentations from occurring and causing irreversible deformation of the heat transfer member 430, thereby minimizing the non-uniformity in the heat dissipation performance of the heat transfer member 430.

According to an embodiment of the disclosure, when the heat transfer member 430 is in the solid state, the material (e.g., a phase change material) contained in the heat transfer member 430 does not permeate into the gap of the shielding structure (e.g., the conductive layer 440 and the shield can 420 in FIG. 3) around the heat transfer member 430. Thus, the shielding performance of the shielding structure may not be impaired. Even if the heat transfer member 430 transitions to a gel state after the operation of the electronic device 101, the heat transfer member 430 only becomes a gel state when it reaches the phase transition temperature Tc after the electronic device 101 has been in operation. The heat transfer member 430, which does not contain substances that cause bleeding, such as silicone resin or oil, may not impair the shielding performance of surrounding shielding structures (e.g., the conductive layer 440 and the shield can 420 in FIG. 3).

According to an embodiment of the disclosure, the heat transfer member 430 may contain a matrix material configured to maintain the heat transfer member 430 in the gel state at a temperature higher than the phase transition temperature Tc. The matrix material may function as a frame of the heat transfer member 430, thereby allowing the heat transfer member 430 to substantially maintain its shape even when its temperature of the heat transfer member 430 rises above the phase transition temperature Tc. For example, the matrix material may be a rubber-based material. The matrix material is not limited to a rubber-based material, and may be replaced with a material that can function as a frame.

According to an embodiment of the disclosure, although the gel states of the heat dissipation material 350 and the heat transfer member 430, after transitioning, share the same name, their properties may differ due to differences in composition or composition ratio. For example, the gel state of the heat dissipation material 350 injected into the inside space 331 may not maintain its shape compared to the gel state of the heat transfer member 430, and thus may flow in the inside space 331. In contrast, the gel state of the heat transfer member 430, compared to the gel state of the heat dissipation material 350, may be understood, for example, as a non-flowing gel state when the shape is maintained by the matrix material.

According to an embodiment of the disclosure, the heat transfer member 430 may include heat dissipation particles. As an example, the heat dissipation particles may be aluminum oxide (Al₂O₃) or aluminum nitride (AlN). As another example, the heat dissipation particles may be carbon fiber, graphene, boron nitride (BN), silicon carbide (SiC), magnesium oxide (MgO), or manganese oxide (ZnO).

According to an embodiment of the disclosure, the heat transfer member 430 may contain heat dissipation particles, a phase change material, and a matrix material. As an example, the heat transfer member 430 may contain about 75 to 90% of heat dissipation particles, about 5 to 15% of matrix material, and about 5 to 15% of phase change material. The composition ratio of the heat dissipation particles, the matrix material, and the phase change material included in the heat transfer member 430 is not limited to the above examples.

According to an embodiment of the disclosure, as the first electronic component E1 and/or the second electronic component E2 operates, the temperature of the heat transfer member 430 may increase due to heat generation from the first electronic component E1 and/or the second electronic component E2. When the temperature of the heat transfer member 430 increases after the first electronic component E1 and/or the second electronic component E2 operates, the heat transfer member 430 may transition to at least partially gel state.

According to an embodiment of the disclosure, the first portion 433 of the heat transfer member 430 in its solid state, prior to transitioning into the gel state, may have a first height h1. The plurality of second portions 431 and 432 may have a first thickness t1 and a second thickness t2, respectively. The distances between the inner surface 430i and the outer surface 430o of the plurality of second portions 431 and 432 may be the first thickness t1 and the second thickness t2, respectively.

According to an embodiment of the disclosure, the inner surfaces 430i of the second portions 431 and 432 of the solid-state heat transfer member 430, prior to transitioning to the gel state, may be spaced apart from the second surface E22 of the second electronic component E2 to facilitate easy coupling of the heat transfer member 430. Therefore, the heat transfer member 430 may be easily assembled to the second electronic component E2.

According to an embodiment of the disclosure, after transitioning to the gel state, the first portion 433 of the heat transfer member 430 in a state pressed by the conductive layer 440 may have a second height h2, which is smaller than the first height h1. The plurality of second portions 431 and 432 of the heat transfer member 430 in a state pressed by the conductive layer 440 may have a third thickness t3 greater than the first thickness t1, and a fourth thickness t4 greater than the second thickness t2, respectively. The third thickness t3 and the fourth thickness t4 may be the maximum thicknesses of the plurality of second portions 431 and 432, respectively.

According to an embodiment of the disclosure, the heat transfer member 430 may be pressed by the conductive layer 440 after transitioning to the gel state. When pressed by the conductive layer 440, the height of the first portion 433 of the heat transfer member 430 may decrease from the first height h1 to the second height h2. The difference between the first height h1 and the second height h2 may be due to assembly tolerances that may occur during the manufacturing process of the board assembly 400. For example, in the process of assembling the components 410, 420, 430, 440, E1, and E2 of the board assembly 400, tolerances such as assembly tolerance and component height tolerance of the second printed circuit board 320 and the electronic components E1 and E2 may occur.

According to an embodiment of the disclosure, the heat transfer member 430 in its gel state may have a higher compressibility compared to the heat transfer member 430 in its solid state. For example, the heat transfer member 430 in its gel state may have a compressibility of about 25 to 40%, and more specifically, about 35 to 40%. Since the heat transfer member 430 of the disclosure has a high compressibility in its gel state compared to its solid state, the above-mentioned tolerances may be absorbed by the heat transfer member 430. For example, when the heat transfer member 430 becomes at least partially in the gel state when its temperature rises above the threshold temperature Tc, it may be configured to have a compressibility of about 35 to 40%, and the second height h2 may be reduced by about 35 to 40% from the first height h1.

According to an embodiment of the disclosure, as the height of the first portion 433 of the heat transfer member 430 decreases, the thicknesses of the second portions 431 and 432 of the heat transfer member 430 may increase. As the thicknesses of the second portions 431 and 432 of the heat transfer member 430 increase, the second portions 431 and 432 may be in close contact with the second surface E22 of the second electronic component E2. As the thicknesses of the second portions 431 and 432 of the heat transfer member 430 increase, the inner surfaces 430i of the second portions 431 and 432 may be in close contact with the second surface E22 of the second electronic component E2. As the thicknesses of the second portions 431 and 432 of the heat transfer member 430 increase, the second portions 431 and 432 may be in close contact with the shield can 420 (see FIG. 3).

According to an embodiment of the disclosure, of outer surfaces E11 and E12 of the first electronic component E1, the first surface E11 may include a first area E111 in which the second electronic component E2 is disposed. Heat may be dissipated from the first electronic component E1 to the second electronic component E2 through the first area E111.

According to an embodiment of the disclosure, of the outer surfaces E11 and E12 of the first electronic component E1, the first surface E11 may include a second area E112 in contact with the second portions 431 and 432 of the heat transfer member 430. The second area E112 may at least partially surround the first area E111. Heat may be dissipated from the first electronic component E1 to the second portions 431 and 432 of the heat transfer member 430 through the second area E112.

According to an embodiment of the disclosure, the first electronic component E1 may include a heat generating block B. The heat generating block B may be positioned below the first surface E11 and may overlap with the second area E112. The heat generating block B may be positioned below the border between the first area E111 and the second border E112. The heat generated from the heat generating block B may be dissipated to the second electronic component E2 through the first area E111. The heat generated from the heat generating block B may be dissipated to the second portion 432 of the heat transfer member 430 through the second area E112.

According to an embodiment of the disclosure, the heat generating block B may include a first heat generating block B1 and a second heat generating block B2. The first heat generating block B1 and the second heat generating block B2 may be positioned below the first surface E11 and overlap with the second area E112. As an example, the first heat generating block B1 may be a CPU of a processor (e.g., the processor 120 in FIG. 1), and the second heat generating block B2 may be a GPU of a processor (e.g., the processor 120 in FIG. 1).

According to an embodiment of the disclosure, the first electronic component E1 may include a heat generating block B. The heat generating block B may be a portion of the first electronic component E1 where the heat generation is relatively high. As an example, the first electronic component E1 may include a processor (e.g., the processor 120 in FIG. 1), and the heat generating block B may include at least one processing core as a CPU/GPU portion. As another example, the heat generating block B may include one of a plurality of processing cores, or a plurality of cores adjacent to each other.

According to an embodiment of the disclosure, the heat generating block B may be positioned at an edge of the first electronic component E1 to be connected to a power source (e.g., the battery 350 in FIG. 2). The heat generating block B may at least partially overlap with a second area E112 of the outer surfaces E11 and E12 of the first electronic component E1. As an example, as illustrated in FIG. 3, the heat generating block B may overlap with the edge of the second electronic component E2 in the direction in which the first electronic component E1 and the second electronic component E2 are stacked. As another example, unlike that illustrated in FIG. 3, the heat generating block B may be positioned outside the edge of the second electronic component E2, so it may not overlap with the edge of the second electronic component E2 in the direction in which the first electronic component E1 and the second electronic component E2 are stacked.

As the integration density and performance of electronic components (e.g., processors and memory) increase, the amount of heat generated by electronic components is also increasing. If the temperature of the electronic components due to heat generation is not reduced, it may affect the operation of the electronic device (e.g., performance degradation due to throttling). Thus, extensive research is being conducted on the heat dissipation structures of electronic components.

A problem that the disclosure seeks to solve may be to minimize the flow of a heat dissipation material in a gel state inside an electronic device.

Another problem that the disclosure seeks to solve may be to reduce the amount of heat dissipation material while ensuring the heat dissipation performance of electronic components (e.g., application processors).

Another problem that the disclosure seeks to solve may be to prevent the outer surface of an electronic device from becoming locally overheated due to the operation of electronic components.

The problems that the disclosure seeks to solve are not limited to the aforementioned problems, and may be expanded in various ways without departing from the spirit and scope of the disclosure.

An electronic device according to various embodiments of the disclosure may minimize the flow of heat dissipation material within an inside space of the electronic device by placing a structure (e.g., a shield can) in the inside space where the gel-state heat dissipation material is injected.

An electronic device according to various embodiments of the disclosure may reduce the amount of injected heat dissipation material while ensuring a certain level of heat dissipation performance by concentrating the heat dissipation material in an area adjacent to an electronic component (e.g., an application processor).

An electronic device according to various embodiments of the disclosure may reduce a user's perceived temperature by preventing local overheating on an outer surface of the electronic device by placing a heat dispersion member (e.g., a vapor chamber) and a heat insulating layer on one side and the other side of an electronic component, respectively.

The effects obtainable from the present disclosure are not limited to the effects mentioned above, and other effects not mentioned may be clearly understood by those skilled in the art to which the disclosure belongs from the description above.

According to an embodiment of the disclosure, an electronic device 101 may include a first printed circuit board 310 including a first surface 311 and a second surface 312 which is opposite the first side 311.

According to an embodiment of the disclosure, the electronic device 101 may include a second printed circuit board 320 spaced apart from the first printed circuit board 310 and including a third surface 321 which faces the first surface 311 and a fourth surface 322 which is opposite the third surface 321.

According to an embodiment of the disclosure, the electronic device 101 may include an interposer 330 disposed between the first printed circuit board 310 and the second printed circuit board 320.

According to an embodiment of the disclosure, the interposer 330 may extend along an edge 321e of the third surface 321 to define an inside space 331.

According to an embodiment of the disclosure, the electronic device 101 may include an electronic component E1 mounted on the fourth surface 322 of the second printed circuit board 320.

According to an embodiment of the disclosure, the electronic device 101 may include a shield can 341 or 344 mounted on the first surface 311 of the first printed circuit board 310.

According to an embodiment of the disclosure, the electronic device 101 may include a heat dissipation material 350 positioned between the third surface 321 and the shield can 341 or 344.

According to an embodiment of the disclosure, the electronic device 101 may include a through hole 313 formed on the first surface 311.

According to an embodiment of the disclosure, the through hole 313 may be disposed outside the shield can 341 or 344.

According to an embodiment of the disclosure, the shield can 341 or 344 may be disposed adjacent to the through hole 313.

According to an embodiment of the disclosure, the shield can 341 or 344 may partially surround the through hole 313.

According to an embodiment of the disclosure, the third surface 321 may include a first area 321c opposite an area of the fourth surface 322 on which the electronic component E1 is mounted.

According to an embodiment of the disclosure, the third surface 321 may include a second area 341a or 344a facing a top surface 341s or 344s of the shield can 341 or 344 and overlapped with the first area 321c.

According to an embodiment of the disclosure, the third surface 321 may include a third area 313a facing the through hole 313.

According to an embodiment of the disclosure, the third area 313a may be disposed inside the first area 321c.

According to an embodiment of the disclosure, the shield can 341 or 344 may include a plurality of shield cans 341 and 344 arranged along a border of the through hole 313 to at least partially surround the through hole 313.

According to an embodiment of the disclosure, the third surface 321 may include a fourth area 321i which is not overlapped with the second area 341a or 344a.

According to an embodiment of the disclosure, the fourth area 321i may surround the third area 313a with the second area 341a or 344a.

According to an embodiment of the disclosure, the fourth area 321i may extend from a side of the third area 313a toward a border of the first area 321c.

According to an embodiment of the disclosure, the heat dissipation material 350 may include a first portion 351 disposed between the top surface 341s or 344s of the shield can 341 or 344 and the second area 341a or 344a of the third surface 321.

According to an embodiment of the disclosure, the heat dissipation material 350 may include a second portion 352 disposed between the first surface 311 and the fourth area 321i of the third surface 321.

According to an embodiment of the disclosure, the width d3 of the end of the fourth area 321i which is adjacent to the third area 313a is greater than the distance d1 between two shield cans 341 and 344 next to each other among the plurality of shield cans 341, 344, and 347.

According to an embodiment of the disclosure, the third area 313a may be disposed at the central portion 321t of the first area 321c.

According to an embodiment of the disclosure, the third surface 321 may a second area 2341a facing the top surface 2341s of the shield can 2341.

According to an embodiment of the disclosure, the second area 2341 may be spaced apart from the first area 321c.

According to an embodiment of the disclosure, the third surface 321 may include a third area 2313a facing the through hole 2313 and disposed between the second area 2341a and the first area 321c.

According to an embodiment of the disclosure, the gap G2 between the third surface 321 and the top surface 341s or 344s of the shield can 341 or 344 which faces the third surface 321 is smaller than the gap G1 between the third surface 321 and the first surface 311.

According to an embodiment of the disclosure, the shield can 3341 or 3344 may include a first shield can 3344 and a second shield can 3341 which at least partially surrounds the through hole 313.

According to an embodiment of the disclosure, the gap G22 between the third surface 321 and the top surface 3341s of the second shield can 3341 may be smaller than the gap G21 between the third surface 321 and the top surface 3344s of the first shield can 3344.

According to an embodiment of the disclosure, when viewed from a direction which the third surface 321 faces, the through hole 313 may be overlapped with the electronic component E1.

According to an embodiment of the disclosure, when viewed from the direction which the third surface 321 faces, the through hole 313 may be spaced apart from the central portion of the electronic component E1

According to an embodiment of the disclosure, when viewed from the direction which the third surface 321 faces, the second shield can 3341 may be closer to the central portion of the electronic component E1 than the first shield can 3344.

According to an embodiment of the disclosure, the electronic device 101 may include a heat dispersion member V disposed between a first outer surface 210A of the electronic device 101 and the electronic component E1 and extending along the first outer surface 210A of the electronic device 101.

According to an embodiment of the disclosure, the shield can 341 may be disposed between the electronic component E1 and a second outer surface 210B of the electronic device 101 which is opposite the first outer surface 210A of the electronic device 101.

According to an embodiment of the disclosure, when viewed from the direction which the third surface 321 faces, the electronic component E1 may be overlapped with the shield can 341.

According to an embodiment of the disclosure, the electronic device 101 may include a heat transfer member 430 disposed between the first electronic component E1 and the heat dispersion member V.

According to an embodiment of the disclosure, the heat transfer member 430 may be in contact with the second electronic component E2 and the first electronic component E1.

According to an embodiment of the disclosure, the electronic device 101 may include a second interposer 4332 spaced inwardly from the first interposer 4331 and extended across the inside space 4331a or 4331b.

According to an embodiment of the disclosure, the second interposer 4332 may be elongated on the third surface 4321 and connected to the first interposer 4331.

According to an embodiment of the disclosure, the second interposer 4332 may divide the inside space 4331a or 4331b into a plurality of mounting spaces 4331a and 4331b.

According to an embodiment of the disclosure, the through hole 4313 and the electronic component E1 may be disposed on opposite sides of one of the plurality of mounting spaces 4331a and 4331b.

Although specific embodiments have been described above in the detailed description of the disclosure, it will be apparent to those skilled in the art that various modifications and changes may be made thereto without departing from the scope of the disclosure.

Although features are described in combination in this disclosure, the scope of the disclosure is not limited to such combinations. In particular, the disclosure covers alternative combinations unless noted as incompatible and features may be omitted from the combinations described herein, for example, when features do not directly interact with other features/components of an embodiment and/or are not required to achieve the advantage of the embodiment. Features that have been described separately may also be combined to form one or more embodiments.

## Claims

1. An electronic device comprising:
a first printed circuit board (310) comprising a first surface (311) and a second surface (312) which is opposite the first surface (311);
a second printed circuit board (320) spaced apart from the first printed circuit board (310) and comprising a third surface (321) which faces the first surface (311) and a fourth surface (322) which is opposite the third surface (321);
an interposer (330) disposed between the first printed circuit board (310) and the second printed circuit board (320), the interposer (330) extending along at least a portion of an edge (321e) of the third surface (321) to define an inside space (331);
an electronic component (E1) mounted on the fourth surface (322) of the second printed circuit board (320);
a shield can (341, 344) mounted on the first surface (311) of the first printed circuit board (310); and
a heat dissipation material (350) positioned between the third surface (321) and the shield can (341, 344).

2. The electronic device of claim 1, further comprising a through hole (313) formed on the first surface (311) and disposed outside the shield can (341, 344),
wherein the shield can (341, 344) is disposed to be adjacent to the through hole (313) and partially surrounds the through hole (313).

3. The electronic device of any one of preceding claims,
wherein the shield can (341, 344) comprises a plurality of shield cans (341, 344) arranged along a border of the through hole (313) to at least partially surround the through hole (313).

4. The electronic device of any one of preceding claims,
wherein the third surface (321) comprises:
a first area (321c) opposite an area of the fourth surface (322) on which the electronic component (E1) is mounted;
a second area (341a, 344a) facing a top surface (341s, 344s) of the shield can (341, 344) and overlapped with the first area (321c); and
a third area (313a) facing the through hole (313) and disposed inside the first area (321c).

5. The electronic device of claim 4,
wherein the third surface (321) comprises a fourth area (321i) which is not overlapped with the second area (341a, 344a) and surrounding the third area (313a) with the second area (341a, 344a), the fourth area (321i) extending from a side of the third area (313a) toward a border of the first area (321c),
wherein the shield can (341, 344) comprises a plurality of shield cans (341, 344), and
wherein a width (d3) of an end of the fourth area (321i) which is adjacent to the third area (313a) is greater than a distance (d1) between a first edge (341b) and a second edge (344b) of the second area (341a, 344a), wherein the first edge (341b) and the second edge (344b) correspond to adjacent side surfaces of two shield cans (341, 344) next to each other among the plurality of shield cans (341, 344, 347).

6. The electronic device of claim 5,
wherein the heat dissipation material (350) comprises:
a first portion (351) disposed between the top surface (341s, 344s) of each of the shield cans (341, 344) and the second area (341a, 344a) of the third surface (321); and
a second portion (352) disposed between the first surface (311) and the fourth area (3211) of the third surface (321).

7. The electronic device of any of claims 1-2,
wherein the third surface (321) comprises:
a first area (321c) which is opposite an area of the fourth surface (322) on which the electronic component (E1) is mounted; and
a second area (2341a) facing a top surface (2341s) of the shield can (2341) and spaced apart from the first area (321c
wherein the third surface (321) comprises a third area (2313a) facing the through hole (2313) and disposed between the second area (2341a) and the first area (321c).

8. The electronic device of any one of preceding claims,
wherein a gap (G2) between the third surface (321) and a top surface (341s, 344s) of the shield can (341, 344) which faces the third surface (321) is smaller than a gap (G1) between the third surface (321) and the first surface (311).

9. The electronic device of any one of claims 1-6,
wherein the shield can (3341, 3344) comprises a first shield can (3344) and a second shield can (3341), and
wherein a gap (G22) between the third surface (321) and a top surface (3341s) of the second shield can (3341) is smaller than a gap (G21) between the third surface (321) and a top surface (3344s) of the first shield can (3344).

10. The electronic device of claim 9,
wherein, when viewed from a direction which the third surface (321) faces, the through hole (313) is overlapped with the electronic component (E1) and is spaced apart from a center portion of the electronic component (E1), and
wherein, when viewed from the direction which the third surface (321) faces, the second shield can (3341) is closer to the center portion of the electronic component (E1) than the first shield can (3344).

11. The electronic device of any one of preceding claims, further comprising a heat dispersion member (V) disposed between a first outer surface (210A) of the electronic device (101) and the electronic component (E1) and extending along the first outer surface (210A) of the electronic device (101),
wherein the shield can (341) is disposed between the electronic component (E1) and a second outer surface (210B) of the electronic device (101) which is opposite the first outer surface (210A) of the electronic device (101).

12. The electronic device of any one of preceding claims,
wherein, when viewed from a direction which the third surface (321) faces, the electronic component (E1) is overlapped with the shield can (341).

13. An electronic device comprising:
a first printed circuit board (4310) comprising a first surface (4311) and a second surface (4312) which is opposite the first surface (4311);
a second printed circuit board (4320) spaced apart from the first printed circuit board (4310) and comprising a third surface (4321) which faces the first surface (4311) and a fourth surface (4322) which is opposite the third surface (4321);
a first interposer (4331) disposed between the first printed circuit board (4310) and the second printed circuit board (4320) and extending along an edge (edge, 4321e) to form an inside space (inside space, 4331a, 4331b);
an electronic component (E1) mounted on the fourth surface (4322) of the second printed circuit board (4320);
a second interposer (4332) spaced inwardly from the first interposer (4331) and extending across the inside surface (4331a, 4331b);
a through hole (4313) disposed at the first surface (4311) of the first printed circuit board (4310); and
a heat dissipation material (4350) injected into the inside surface (4331a, 4331b) through the through hole (4313).

14. The electronic device of claim 13,
wherein the second interposer (4332) is elongated on the third surface (4321) and connected to the first interposer (4331).

15. The electronic device of claim 13 or 14,
wherein the second interposer (4332) divides the inside space (4331a, 4331b) into a plurality of mounting spaces (4331a, 4331b), and
wherein the through hole (4313) and the electronic component (E1) are disposed on opposite sides of one of the plurality of mounting spaces (4331a, 4331b).
